(12)  **EUROPEAN PATENT SPECIFICATION**

(45) Date of publication and mention
of the grant of the patent:
**07.07.1999 Bulletin 1999/27**

(51) Int Cl.6: **H05H 1/18**, H05H 1/46,
H01S 3/097

(21) Application number: **95108095.1**

(22) Date of filing: **23.01.1988**

(54) **Laser Plasma apparatus**

Laser Plasmavorrichtung

Appareil laser à plasma

(84) Designated Contracting States:
**DE FR GB**

(30) Priority: 26.01.1987 JP 1569087
28.01.1987 JP 1807187
06.08.1987 JP 19518587
10.09.1987 JP 22520287
10.09.1987 JP 22520587
10.09.1987 JP 22520687
10.09.1987 JP 22520887
10.09.1987 JP 22520987
10.09.1987 JP 22521187
10.09.1987 JP 22521487
10.09.1987 JP 22521587
10.09.1987 JP 22521987
10.09.1987 JP 22522087
10.09.1987 JP 22522187
10.09.1987 JP 22522287
10.09.1987 JP 22522487

(43) Date of publication of application:
**27.09.1995 Bulletin 1995/39**

(62) Document number(s) of the earlier application(s) in
accordance with Art. 76 EPC:
**88101007.8 / 0 280 044**

(73) Proprietor: **MITSUBISHI DENKI KABUSHIKI
KAISHA
Tokyo 100 (JP)**

(72) Inventors:
- **Nishimae, Junichi, c/o Mitsubishi Denki K.K.
8-chome, Amagasaki-shi, Hyogo (JP)**
- **Yoshizawa, Kenji, c/o Mitsubishi Denki K.K.
8-chome, Amagasaki-shi, Hyogo (JP)**
- **Taki, Masakazu, c/o Mitsubishi Denki K.K.
8-chome, Amagasaki-shi, Hyogo (JP)**
- **Ueda, Yoshihioro, c/o Mitsubishi Denki K.K.
8-chome, Amagasaki-shi, Hyogo (JP)**
- **Yanagi, Tadashi, c/o Mitsubishi Denki K.K.
8-chome, Amagasaki-shi, Hyogo (JP)**
- **Iwata, Akihiko, c/o Mitsubishi Denki K.K.
8-chome, Amagasaki-shi, Hyogo (JP)**

(74) Representative: **Eisenführ, Speiser & Partner
Martinistrasse 24
28195 Bremen (DE)**

(56) References cited:
**EP-A- 0 031 907          EP-A- 0 122 403
US-A- 4 543 465**

- **CONFERENCE ON LASERS AND
ELECTRO-OPTICS, OSA/IEEE, DIGEST OF
TECHNICAL PAPERS, SAN FRANCISCO, CA,
9-13TH JUNE 1986, pages 162-164, L.A.
NEWMAN ET AL. 'High power coupled CO2
waveguide laser array'**
- **REVIEW OF SCIENTIFIC INSTRUMENTS, vol. 57,
no. 2, February 1986 NEW YORK US, pages
164-166, L.G. MEINERS ET AL. 'Simple low-cost
microwave plasma source'**

## Description

### Field of the Invention

The present invention relates to a plasma apparatus which generates plasma utilizing microwave discharge and performs laser excitation and can be utilized in plasma processing.

### Description of the Prior Art

In the prior art, there are various plasma apparatuses utilizing microwave discharge, such as a laser apparatus, a light source apparatus, a plasma processing apparatus, an ion source or the like.

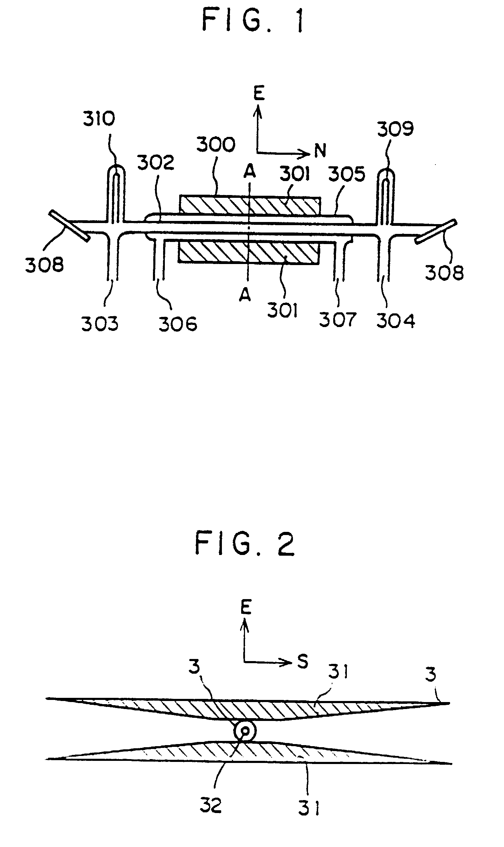

FIG. 1 is a sectional view of a gas laser apparatus in the prior art disclosed, for example, in Journal of Applied Physics, vol. 49, No. 7, July 1978, p. 3753, and FIG. 2 is a sectional view taken in line A-A in FIG. 1. In the figures, numeral 300 designates a waveguide or transmitting microwave, numeral 301 designates a waveguide taper provided on a portion of the waveguide 300, numeral 302 designates a laser discharge tube of Pyrex glass installed in a space of the waveguide taper, numeral 303 designates a laser gas inlet port provided on an end of the laser discharge tube 302, numeral 304 designates a laser gas outlet port provided also on an end of the laser discharge tube 302, numeral 305 designates a cooling gas feed tube installed to surround the laser discharge tube 302, numeral 306 designates a cooling gas inlet port provided on an end of the cooling gas feed tube 305, numeral 307 designates a cooling gas outlet port provided also on an end of the cooling gas feed tube 305, numeral 308 designates Brewster windows installed on both ends of the laser discharge tube 302, numeral 309 designates a cathode for DC discharge, and numeral 310 designates an anode also for DC discharge.

In the gas laser apparatus of the prior art as above described, a laser gas such as $CO_2$ laser gas is introduced from the laser gas inlet port 303 into the laser discharge tube 302, and on the other hand microwave of TE10 mode is excited in the waveguide 300. Since the waveguide 300 has the waveguide taper 301 on inside and the inner diameter of the waveguide 300 becomes minimum at the installation position of the laser discharge tube 302, the electric field intensity of the microwave becomes maximum in this position. The strong microwave field causes discharge breakdown of the laser gas within the laser discharge tube 302 and generates plasma and excites the laser medium. Then $N_2$ gas of low temperature for example flows in the cooling gas feed tube 305 at high speed and the laser discharge tube 302 is cooled from outside and the discharge condition such as pressure of the laser gas is suitably selected thereby the laser oscillation condition is obtained, and further mirrors for laser oscillation (not shown) are installed on outside of the Brewster windows 308 thereby the laser oscillation is performed.

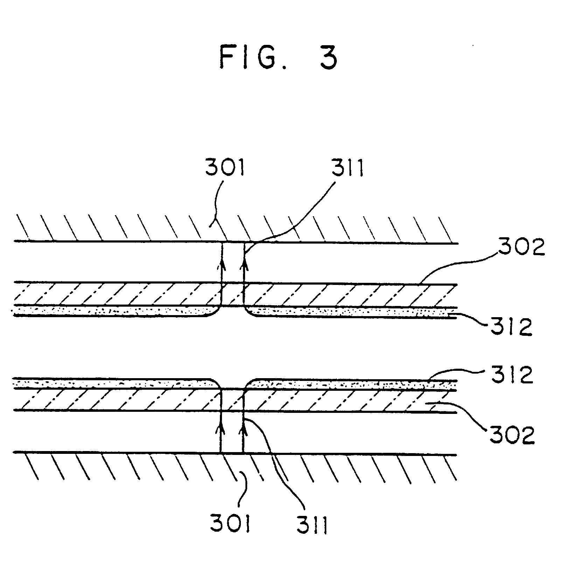

In the gas laser apparatus of the prior art as above described, since the closed laser discharge tube 302 is used, if plasma with conductive property is generated, microwave mode of coaxial mode using plasma in the laser discharge tube 302 as the inner conductor becomes predominant and the microwave field in the plasma becomes electric field which component parallel to the tube wall of the discharge tube 302 is main component, thereby microwave entering the plasma substantially becomes mode being incident perpendicularly to the tube wall of the laser discharge tube 302, i.e., the plasma boundary. In such discharge produced by the microwave being incident perpendicularly to the plasma boundary, the microwave field is decreased from the discharge tube wall towards inside, but since the discharge plasma has constant-voltage characteristics, the current density varies significantly depending on slight variation of the electric field. As a result, the plasma is generated and centered upon position near the discharge tube wall and becomes significantly uneven. This state is shown in a sectional view of FIG. 3. In FIG. 3, numeral 311 designates electric line of force of the microwave electric field, and numeral 312 designates plasma. In a gas laser apparatus utilizing microwave discharge in the prior art, since uneven plasma as shown in FIG. 3 is generated, it is difficult that discharge as a whole is made suitable for the laser excitation. Moreover, the laser resonator mode and the plasma are not overlapped with each other thereby the laser output or efficiency becomes low.

In fact, in the apparatus of the prior art shown in FIG. 2, when microwave is 2.45 GHz and pulse microwave of 132 Hz is used and the apparatus is operated at pulse width 1 μs and peak power 2.6 kW, mean output of only 15 mW is obtained. This is because the apparatus can be operated only at pulse width 1 μs, 132 Hz, i.e., at very low pulse duty being about 1/10,000 due to unevenness of discharge as above described. Moreover, since the apparatus is operated at such slow repetition as 132 Hz, the plasma becomes uneven in aspect of time and therefore only laser oscillation by pulse can be performed. Such problems are produced not only in the gas laser apparatus, but various problems are produced also in other plasma apparatuses due to unevenness of discharge.

Also in the prior art, there is an optical waveguide type gas laser apparatus where laser gas is filled in a space acting as an optical waveguide to guide generated laser rays, and plasma is generated in the laser gas by discharge so as to perform laser excitation.

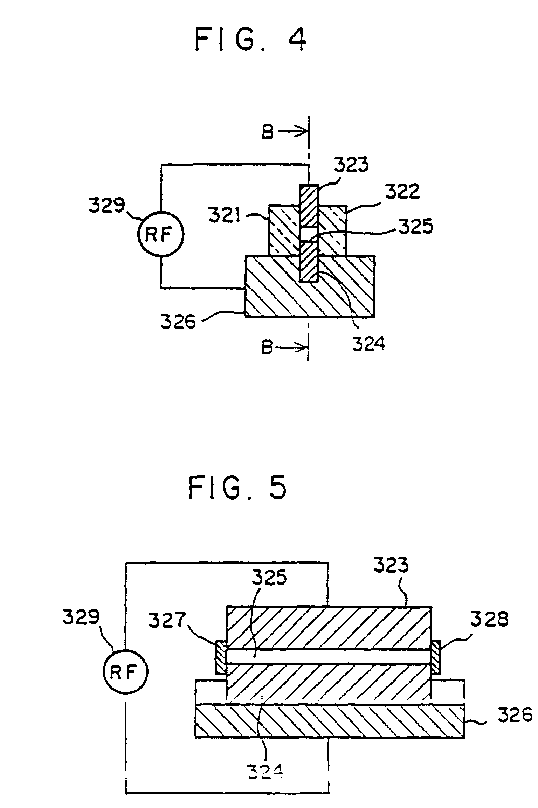

FIG. 4 is a sectional view of an optical waveguide type gas laser apparatus in the prior art disclosed, for example, in Japanese patent application laid-open No. 54-103692, and FIG. 5 is a sectional view taken along line B-B in FIG. 4. In the figures, numerals 321, 322 designate a pair of long dielectrics opposite to each other, numerals 323, 324 designate a pair of long electrodes opposite to each other between these dielectrics 321, 322 with a prescribed spacing, numeral 325 designates a discharge space where all sides are defined by these dielectrics 321, 322 and electrodes 323, 324 and laser gas is filled therein so as to perform laser excitation by discharge, numeral 326 designates a block of material with high thermal conductivity, on which these dielectrics 321, 322 and electrodes 323, 324 are installed, numeral 327 designates a total reflection mirror arranged on one end of the discharge space 325, numeral 328 designates a partial transmission mirror arranged on other end of the discharge space 325 in opposition to the total reflection mirror 327, and numeral 329 designates a high-frequency voltage source for applying high-frequency electric field to the electrodes 323, 324. In this case, the discharge space 325 has dimension suitable to guide the generated laser rays, and acts also as an optical waveguide.

Next, operation will be described. Laser gas is introduced into the discharge space 325, and high-frequency voltage is supplied between the electrodes 323 and 324 from the high-frequency voltage source 329. Thereby the strong high-frequency electric field is applied to the laser gas in the discharge space 325, and the discharge breakdown of the laser gas is produced by the high-frequency electric field and plasma is generated and the laser excitation is performed. The generated laser rays pass through the discharge space 325 as optical waveguide and are reflected between the total reflection mirror 327 and the partial transmission mirror 328 arranged on both ends of the discharge space 325, and a part of the laser rays is taken to outside by the partial transmission mirror 328.

Since the optical waveguide type gas laser apparatus in the prior art is constituted as above described, it is difficult that frequency of the high-frequency voltage applied between the electrodes 323 and 324 is made higher than certain extent. Moreover, as the frequency of the high-frequency voltage is increased, the discharge in the discharge space 325 is concentrated to surface portion of the dielectrics 321, 322 arranged on both sides of the discharge space 325, thereby uniform plasma cannot be obtained and it is difficult that the discharge space 325 as a whole is made suitable for the laser excitation.

In any of the gas laser apparatuses in the prior art as above described, since the laser discharge tube as a whole is made of Pyrex glass, heat generated within the laser discharge tube cannot be radiated efficiently and the temperature rise of the laser gas such as $CO_2$ gas causes decrease of the laser output.

From the publication of L.A. Newman et al.: "High power coupled C02 waveguide laser array" in "Conference on lasers and electro-optics", OSA/IEEE, Digest of technical papers, San Francisco, CA, 9-13 June 1986, pages 162-164, IEEE, New York, US, a laser array is known, wherein microwave from a microwave oscillator is transmitted through a microwave transmission path to the plasma generating medium, said medium being filled in a space between a first conductor wall and a ceramic insert, said ceramic insert having at its back a second conductor wall, both conductor walls forming part of the microwave transmission path. As the electric field invades the plasma from both sides to the center, the invading electric field is parallel to the respective part of the boundary between the dielectrics and the plasma which results in a strong skin effect at the incidence region. This skin effect strongly increases with increasing frequency and prevents a uniform current distribution in the plasma. In view of this, normal discharge cannot be generated in this known array at a microwave region above 300 MHz neither in continuous mode operation nor in a pulsed mode operation.

SUMMARY OF THE INVENTION

A first object of the present invention is to provide a plasma apparatus wherein plasma being uniform in space and stable is generated, and laser operation of high efficiency and large output is possible, and further filling of the plasma generating medium is simple.

A second object of the present invention is to provide a plasma apparatus of high efficiency and long life, wherein a wall surface of a discharge space is protected, and deterioration of a plasma generating medium is prevented.

A third object of the present invention is to provide a plasma apparatus of large diameter, wherein uniform discharge is obtained even at a discharge space of large area.

A fourth object of the present invention is to provide a plasma apparatus wherein microwave discharge plasma becomes uniform in space even in an optical waveguide type gas laser apparatus.

A fifth object of the present invention is to provide a plasma apparatus wherein generated microwave discharge plasma is made uniform in space, and cooling efficiency of a discharge tube is improved, and further laser operation of high efficiency and large output is possible.

A sixth object of the present invention is to provide a plasma apparatus wherein a plasma generating medium filled in a discharge space can be prevented from leakage.

A seventh object of the present invention is to provide a power source apparatus of small size, which can be used as a power source of a plasma apparatus and does not require a high-voltage power source for pulse control.

In order to attain the foregoing objects, a plasma apparatus according to the present invention comprises a microwave oscillator for generating microwaves, a microwave circuit for generating a plasma by microwave discharge within the microwave circuit, and a transmission path for transmitting the microwaves from the microwave oscillator to the microwave circuit, where a plasma generating medium for generating the plasma is filled in a space formed between a conductor wall and dielectrics installed opposite to the conductor wall, and the microwave circuit is arranged for coupling main energy of the microwaves onto the dielectrics such that a pregiven microwave mode propagates through the boundary existing between the dielectrics and the plasma, the microwave oscillator being an oscillator for generating microwaves pulsed by a pregiven pulse frequency, and the dielectrics and the conductor wall being configured such that the electric field component of said microwave mode is orthogonal to that part of the boundary through which the microwaves invade the plasma.

Consequently, in the plasma apparatus according to the invention, since the conductor wall having higher conductivity than that of the plasma exists in opposition to dielectrics as a microwave incident window, the end current of the incident microwave flows through the conductor wall, thereby current penetrating between the dielectrics and the conductor wall flows in the plasma so as to generate the plasma being uniform in space.

The plasma apparatus according to the present invention generates plasma by microwave discharge in pulse microwave. Thereby the plasma becomes further uniform in space.

In a plasma apparatus according to the present invention, microwave excited in a microwave circuit is made pulse microwave where quiescent time is shorter than thermal time constant of a plasma generating medium, for example, $CO_2$ laser gas. Consequently, in the plasma apparatus of this invention, the plasma can be made uniform also in time.

In a plasma apparatus according to the present invention, a conductor wall surface to constitute the space is coated with a ceramic layer so as to protect the wall surface, thereby deterioration of a plasma generating medium is prevented and plasma discharge at high efficiency and long life becomes possible.

In a plasma apparatus according to the present invention, a reservoir tank communicating with the space is installed to store a plasma generating medium, thereby a compact plasma apparatus with high efficiency, large output and long life can be obtained.

In a plasma apparatus according to the present invention, first and second dielectrics are arranged to a bottom surface and a side surface of the space constituted by the conductor wall, thereby plasma with high uniformity can be generated even in the discharge space of large area.

In an optical waveguide type gas laser apparatus in plasma apparatuses according to the present invention, a space as an optical waveguide is formed by a conductor wall to constitute a part of a microwave circuit and dielectrics installed opposite to the conductor wall, and a laser gas as a plasma generating medium is filled in the space, and further microwave is incident thereto using the dielectrics as a microwave incident wall, thereby microwave mode having vertical electric field component is formed at the boundary between the dielectrics and the plasma generated in the laser gas.

Consequently, in the optical waveguide type gas laser apparatus in plasma apparatuses according to the present invention, high-frequency voltage is not applied between two electrodes, but microwave is incident thereto using the dielectrics as a microwave incident window thereby laser excitation by microwave becomes possible. Furthermore, since a conductor wall having higher conductivity than that of the plasma exists in opposition to the dielectrics to which the microwave is incident, the end current of the incident microwave flows through the conductor wall, thereby current penetrating between the dielectrics and the conductor wall flows in the plasma so as to generate the plasma being uniform in space.

In a plasma apparatus according to the present invention, among a space formed between a conductor wall and dielectrics for filling a plasma generating medium therein, a portion other than the dielectrics of the space is partially formed by a gas permeable member, and circulation means for circulating the plasma generating medium within the space is installed through the gas permeable member. Thereby uniform plasma is generated in the plasma generating medium. Furthermore, since the laser gas within the space is circulated through the gas permeable member to reflect microwave, heat generated in the laser gas is radiated efficiently and the temperature rise of the laser gas is prevented.

In a preferred embodiment of the plasma apparatus according to the present invention the microwave is pulsed with a pulse frequency of 500 Hz or more.

In a plasma apparatus according to the present invention preferably DC is converted into AC having frequency higher than the commercial frequency by an DC-AC inverter, and stepped up by a transformer, and then pulsed microwave is generated by a microwave oscillator driven by a power source to generate high voltage in ripple by a half-wave voltage multiplying circuit.

In a plasma apparatus according to the present invention preferably the pulsed microwave is generated by a microwave oscillator driven by a high-voltage pulse source where DC of high voltage is interrupted by a switching element.

In a plasma apparatus according to the present invention preferably the pulsed microwave has a quiescent time less than the thermal time constant of the plasma generating medium.

In a plasma apparatus according to the present invention preferably the power source apparatus to supply pulse voltage to the microwave oscillator is a power source apparatus to drive a non-linear element or device where current does not flow at voltage less than the prescribed voltage $E_Z$ and current flows at the prescribed voltage $E_Z$ or more, and a semiconductor switching element to control power source flowing from voltage source to the non-linear element or device is connected in series to the non-linear element or device.

In a plasma apparatus according to the present invention, preferably the non-linear element or device is provided with dividing resistors connected in parallel.

In a plasma apparatus according to the present invention, preferably the semiconductor switching element has a withstand voltage being lower than voltage $E_O$ of the voltage source and higher than $E_O - E_z$.

In a plasma apparatus according to the present invention, preferably a plurality of semiconductor switching elements are connected in series.

In a plasma apparatus according to the present invention, preferably the semiconductor switching element is a field effect transistor.

In a plasma apparatus according to the present invention, preferably the semiconductor switching element is a bipolar transistor and preferably the non-linear element is a magnetron.

In a plasma apparatus according to the present invention, the microwave transmission path and the microwave circuit are arranged in parallel along the laser optical axis, thereby discharge length which is sufficient to increase laser output and uniform can be secured, and the apparatus as a whole is made compact, and further space factor and control property can be significantly improved in comparison to the prior art.

The foregoing and other objects and advantages of the invention will be apparent from the following detailed description taken in connection with the accompanying drawings.

BRIEF DESCRIPTION OF THE DRAWINGS

FIG. 1 is a sectional view of a gas laser apparatus in the prior art;
FIG. 2 is a sectional view taken in line A-A of FIG. 1;
FIG. 3 is a sectional view illustrating state of discharge in a gas laser apparatus in the prior art;
FIG. 4 is a sectional view of an optical waveguide type gas laser apparatus in the prior art;
FIG. 5 is a sectional view taken along line B-B of FIG. 4;
FIG. 6 is an appearance view of a gas laser apparatus as a first embodiment of the present invention;
FIG. 7 is a sectional view taken in line C-C of FIG. 6;
FIG. 8 is an enlarged sectional view of main part illustrating state of discharge in FIG. 7;
FIG. 9 is a graph illustrating laser oscillation characteristics in FIG. 6 and FIG. 7;
FIG. 10 is diagrams illustrating various constitution examples of a discharge space 13;
FIG. 11 is diagrams illustrating another embodiment of a microwave circuit;
FIG. 12 is diagrams illustrating still another embodiment of a microwave circuit;
FIG. 13 is diagrams illustrating an embodiment where plasma is generated in a part of a discharge space 13;
FIG. 14 is a circuit diagram of a power source to drive a magnetron 1 in a gas laser apparatus as a second embodiment of the present invention;
FIG. 15 is a diagram illustrating waveform of microwave generated by the magnetron 1;
FIG. 16 is a circuit diagram illustrating another embodiment of a power source apparatus;
FIG. 17 is a graph illustrating relation between anode applied voltage and current of a magnetron M in the power source apparatus of FIG. 16;
FIG. 18 is a circuit diagram of a further embodiment of a power source apparatus;
FIG. 19 is a sectional view of a gas laser apparatus as a fourth embodiment;
FIG. 20 is a sectional view of a gas laser apparatus as a fifth embodiment;
FIG. 21 is diagrams illustrating state of discharge in the fifth embodiment;
FIG. 22 is a sectional view of an optical waveguide type gas laser apparatus as a sixth embodiment;
FIG. 23 is a sectional view of a gas laser apparatus as a seventh embodiment;
FIG. 24 is a diagram illustrating constitution of a gas permeable member 67;
FIG. 25 is a view illustrating a modification of FIG. 24;
FIG. 26 is a sectional view of a gas laser apparatus as an eighth embodiment;
FIGS. 27 through 30 are diagrams illustrating modifications of FIG. 7;
FIG. 31 is a sectional view of a gas laser apparatus as a ninth embodiment;
FIG. 32 is a sectional view of a gas laser apparatus as a tenth embodiment;
FIG. 33 is a detailed view of main part of FIG. 32;
FIG. 34 is a sectional view of a gas laser apparatus as an eleventh embodiment;

FIG. 35 is a detailed view of main part of FIG. 34;
FIG. 36 is an appearance view of a gas laser apparatus as a twelfth embodiment;
FIG. 37 is a sectional view of FIG. 36;
FIG. 38 is an appearance view of a gas laser apparatus as a thirteenth embodiment; and
FIG. 39 is an appearance view of a gas laser apparatus as a fourteenth embodiment.

DETAILED DESCRIPTION OF THE PREFERRED EMBODIMENTS

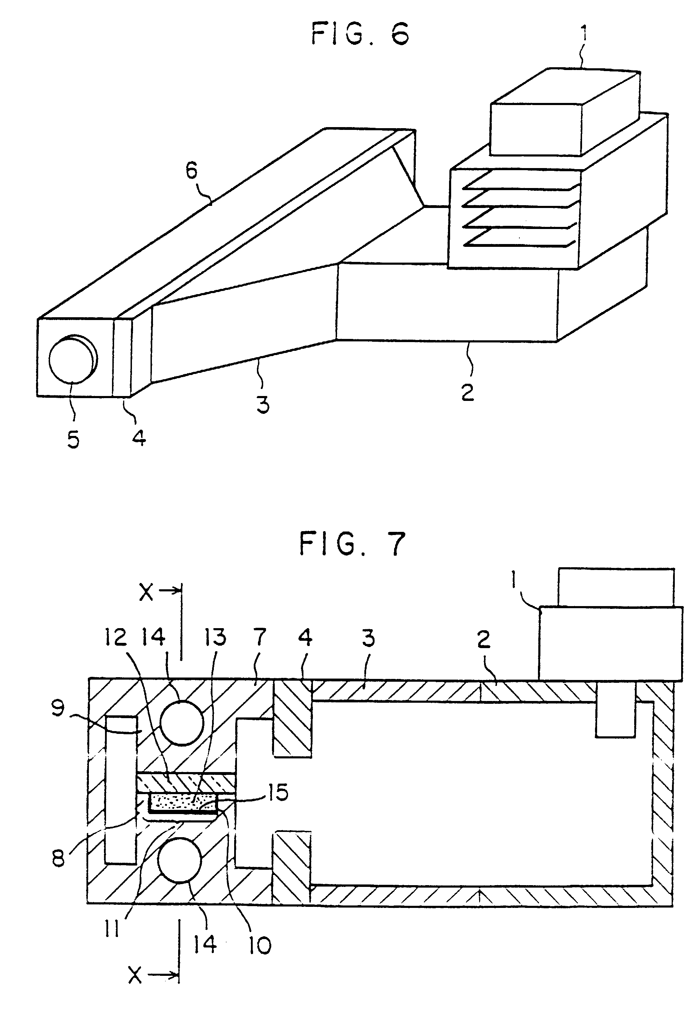

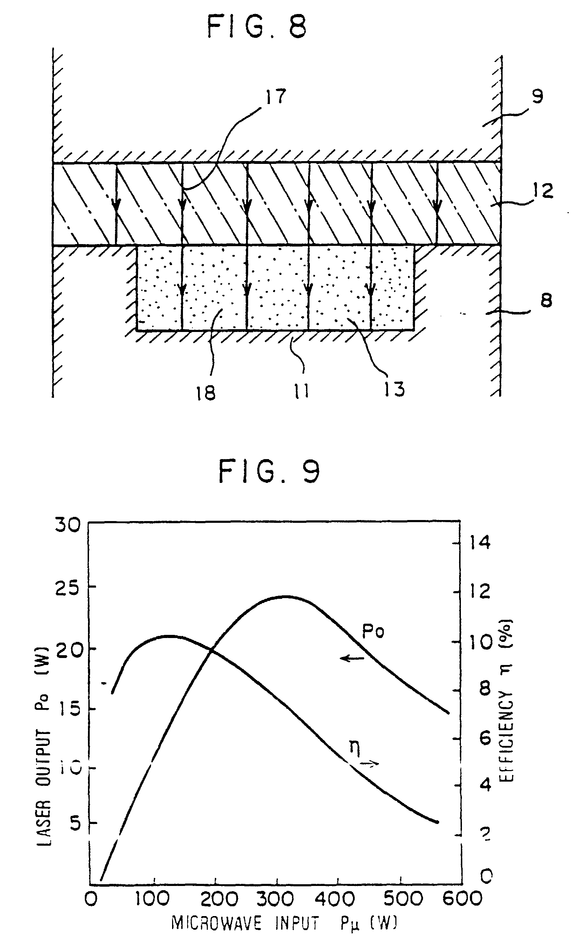

FIG. 6 is an appearance view of a gas laser apparatus as an example of plasma apparatuses in a first embodiment of the present invention. In FIG. 6, reference numeral 1 designates a magnetron being a microwave oscillator, numeral 2 designates a waveguide, numeral 3 designates a horn waveguide to enlarge width of the waveguide 2, numeral 4 designates a microwave coupling window, numeral 5 designates a mirror for laser oscillation, and numeral 6 designates a laser head section. FIG. 7 is a sectional view taken in line C-C of FIG. 6 illustrating details of the gas laser apparatus. As shown in FIG. 7, the laser head section 6 has structure of a microwave cavity of ridge waveguide type being a sort of a microwave circuit. In FIG. 7, numeral 7 designates a cavity wall following the microwave coupling window 4, numerals 8 and 9 designate ridges formed on center portion of section of the cavity wall 7, numeral 10 designates a groove formed on one ridge 8, and numeral 11 designates a conductor wall to constitute a part of the microwave circuit and the wall surface of the groove 10 is used therefor in this embodiment. Numeral 12 designates dielectrics such as alumina installed opposite to the conductor wall 11 for acting as an incident window of microwave, and numeral 13 designates a discharge space formed between the conductor wall 11 and the dielectrics 12 when the dielectrics 12 cover the groove 10, and a laser gas such as $CO_2$ laser gas being a plasma generating medium is filled in the discharge space 13. Numeral 14 designates a cooling water path formed in the ridges 8 and 9.
In the gas laser apparatus according to the invention constituted as above described, microwave generated by the magnetron 1 passes through the waveguide 2 and is widened by the horn waveguide 3. After taking impedance matching by the microwave coupling window 4 for good efficiency, the microwave is coupled with the laser head section 6. Since the laser head section 6 has cross-section of ridge cavity form as shown in FIG. 7, the microwave is concentrated between the ridges 8 and 9. The strong electromagnetic field of the concentrated microwave causes the discharge breakdown of the laser gas filled in the discharge space 13 and generates plasma and excites the laser medium. Then a cooling water flows in the cooling water path 14 so as to cool the discharge plasma, and discharge conditions such as pressure of the laser gas are suitably selected thereby the laser oscillation conditions can be obtained. Then a laser resonator is formed by the mirror 5 in FIG. 6 and another mirror (not shown) thereby the laser oscillation rays can be obtained.
In this case, in the gas laser apparatus according to the present invention, since microwave discharge is performed in the discharge space 13 formed between the conductor wall 11 to constitute a part of the microwave circuit and the dielectrics 12 as a microwave incident window installed opposite to the conductor wall 11, it follows that the entering of the microwave is performed only from one side of the plasma. Consequently, such phenomenon does not occur that microwave mode of coaxial mode using the plasma as inner conductor becomes predominant, thereby discharge by expected microwave mode can be performed.
When the microwave circuit forms microwave mode having electric field component being perpendicular to the boundary between the dielectrics 12 and the plasma as in the ridge cavity shown in FIG. 7, since the dielectrics 12 and the conductor wall 11 are installed opposite to each other, the microwave mode has the electric field component also perpendicular to the conductor wall 11 thereby the electric field penetrating the plasma is formed. In this case, even if plasma having conductive property is generated, since the conductor wall 11 having conductivity higher than that of the plasma by several figures is opposed to the dielectrics 12 as the microwave incident window, the end current of the incident microwave flows through the conductor wall 11 and the electric field near the conductor wall 11 is forcedly made perpendicular to the surface of the conductor wall 11, thereby the electric field penetrating the plasma is maintained. Consequently the microwave enters the plasma and current flows penetrating the plasma, thereby the discharge plasma being uniform in space can be obtained because of continuity of current. This state is shown in an enlarged sectional view of FIG. 8. In FIG. 8, numeral 17 designates electric line of force of the microwave electric field, and numeral 18 designates discharge plasma. According to the gas laser apparatus of the invention, since uniform discharge as shown in FIG. 8 is obtained, the discharge as a whole can be easily made suitable for the laser excitation and also the laser resonator mode and the plasma are overlapped well, thereby the laser oscillation can be obtained at significantly high efficiency and large output in comparison to a gas laser apparatus utilizing microwave discharge in the prior art.
Moreover, since the dielectrics 12 and the ridge 8 on which the groove 10 is formed are closely contacted with each other in surface and the laser gas is filled therein, when pressure of the laser gas is lower than the atmospheric pressure, for example, in the case of $CO_2$ gas laser apparatus, the external pressure is applied to the dielectrics 12 thereby the laser gas can be easily sealed. If necessary, the closely contacted surface may be bonded by an adhesive agent or separate pressure may be applied from outside, and at any case the laser gas can be sealed quite easily by structure that the groove 10 is covered by the dielectrics 12.

Although the microwave cavity of ridge waveguide type is used in the microwave circuit in the embodiment as above described, a microwave circuit of other type such as rectangular cavity may be used and similar effect to the above-mentioned effect can be obtained.

FIG. 9 is a graph illustrating experiment results when the apparatus having the constitution shown in FIG. 6 and FIG. 7 and the discharge length 300 mm is applied to the $CO_2$ laser. In FIG. 9, abscissa indicates microwave input of frequency 2.45 GHz, and ordinate indicates the $CO_2$ laser output and efficiency. As shown in FIG. 9, maximum output 24 W and maximum efficiency 10.5% are obtained, that is, the output becomes larger than the $CO_2$ laser output 15 mW reported in the prior art shown in FIGS. 1 and 2 by three figures or more. Furthermore, although only pulse oscillation can be obtained in the prior art, it has been confirmed that the CW oscillation can be performed in the apparatus according to the present invention.

According to the gas laser apparatus in the first embodiment of the present invention, since the metal wall to confine the microwave and the discharge plasma are closely contacted with each other, the cooling can be performed from outside of the metal wall freely and effectively. Consequently, the apparatus is favorably applied to a laser where cooling of the laser gas is important, for example, $CO_2$ laser. Moreover, since effect of the magnetic field is not used, the apparatus can be applied also to a high pressure laser such as eximer laser, and a device for generating the magnetic field is not required and therefore the apparatus becomes compact and simple.

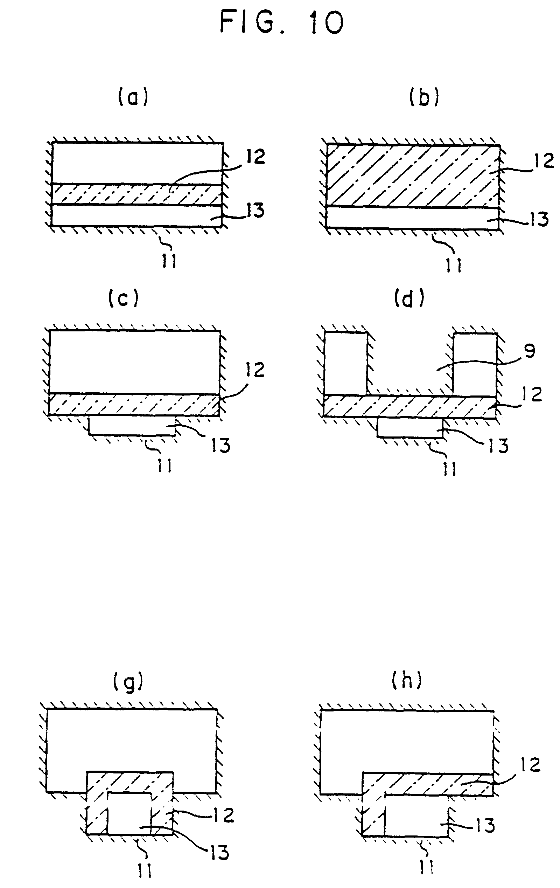

The above-mentioned gas laser apparatus can take further various apparatus constitutions depending on sorts of the microwave circuit and constitution methods of the discharge space 13. FIG. 10 is sectional views illustrating examples of constitution methods of the discharge space 13 where a microwave cavity or a waveguide is used as a microwave circuit. In FIG. 10, numeral 11 designates a conductor wall, numeral 12 designates dielectrics, and numeral 13 designates a discharge space. In FIG. 10(a), the microwave cavity is partitioned by the dielectrics 12 so as to form the discharge space 13, and the apparatus is advantageous in the easy manufacturing. In FIG. 10(b), space other than the discharge space 13 is filled with the dielectrics 12, thereby unnecessary discharge in the space other than the discharge space 13 can be prevented. In FIG. 10(c), the groove formed on the cavity wall is made the discharge space 13, and the apparatus is advantageous in that the discharge space 13 of any size can be formed. In FIG. 10(d), the ridge 9 is added to the apparatus in FIG. 10(c), and the apparatus in FIG. 10(d) is advantageous in comparison to the apparatus in FIG. 10(c) in that the laser gas of high pressure can be discharged, and the matching becomes easy.

FIGS. 10(g), (h) show utilization in combination of these constitutions. As shown in FIG. 10, the conductor wall 11 to constitute a part of the microwave circuit and the dielectrics 12 installed opposite to the conductor wall 11 are suitably selected, thereby the discharge space 13 can be designed considerably freely, and uniform discharge similar to that shown in FIG. 8 can be obtained.

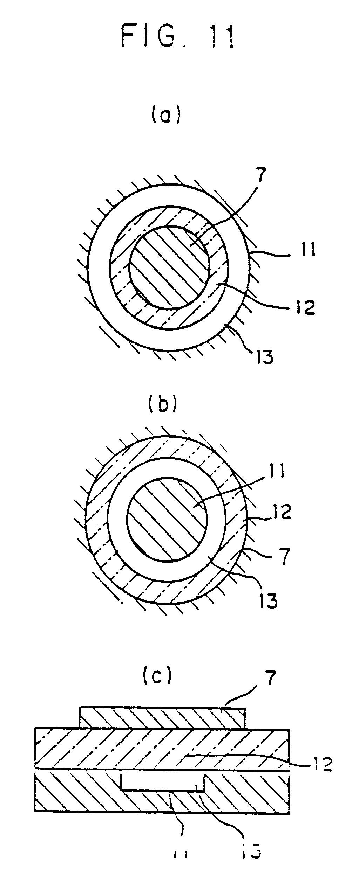

FIG. 11 is sectional views illustrating embodiments where a coaxial line or a strip line is used as a microwave circuit. FIG. 11(a) shows an embodiment where the outer conductor of the coaxial line is utilized as the conductor wall 11 to constitute a part of the microwave circuit, FIG. 11(b) shows an embodiment where the inner conductor of the coaxial line is made the conductor wall 11, and FIG. 11(c) shows an embodiment where the strip line is used. Since the coaxial line and the strip line shown in FIG. 11 do not have the cutoff frequency, for example, when the microwave of 245 GHz is used, the apparatus as a whole can take compact apparatus constitution in comparison to the apparatus using the microwave cavity and therefore is advantageous. In each of FIGS. 11(a), (b), (c), of course, various apparatus constitutions corresponding to the constitution methods of the discharge space shown in FIG. 10 can be taken.

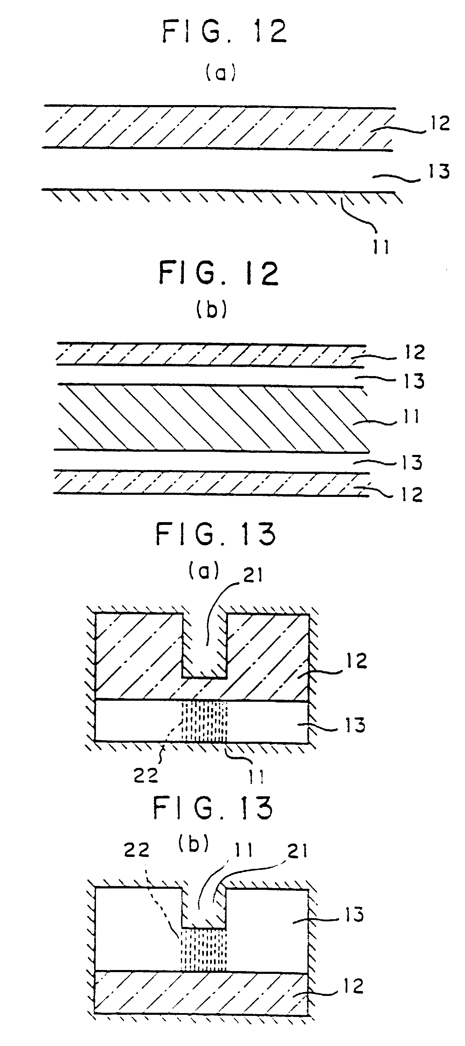

FIG. 12 is sectional views illustrating embodiments where a surface wave line is used as a microwave circuit. FIG. 12(a) shows an embodiment where a conductor flat plate is made the conductor wall 11 and a dielectric flat plate is made the dielectrics 12 so that the discharge space 13 is formed and at the same time the surface wave line is constituted, and FIG. 12(b) shows an embodiment where a conductor circular cylinder is made the conductor wall 11 and a dielectric tube surrounding the conductor circular cylinder is made the dielectrics 12 so that the discharge space 13 is formed and at the same time the surface wave line is constituted. As shown in FIG. 12, when the surface wave line is used, the microwave circuit and the discharge space can be constituted simultaneously using the minimum components, and the apparatus is simplified and advantageous. Also in each of the embodiments of FIGS. 12(a), (b), various apparatus constitutions corresponding to the constitution methods of the discharge space shown in FIG. 10 can be taken.

In the embodiments as hereinbefore described, although the plasma is generated substantially in the whole of the discharge space 13 formed between the conductor wall 11 to constitute a part of the microwave circuit and the dielectrics 12 installed opposite to the conductor wall 11, the plasma may be generated only in a part of the discharge space 13. FIG. 13 is sectional views illustrating embodiments where a projection 21 is provided on a part of the microwave circuit, and plasma 22 is generated in the strong electromagnetic field formed in a part of the discharge space by the projection 21. FIG. 13(a) shows an embodiment where the projection 21 is provided on outside of the discharge space 13, and FIG. 13(b) shows an embodiment where the projection 21 is provided on inside of the discharge space 13. According to the constitution of FIG. 13, the discharge plasma can be concentrated only in a part of the discharge space 13, and a laser apparatus of three-axis orthogonal type can be easily obtained. Also the laser gas of high pressure can be discharged, and the plasma of high discharge power density can be easily generated.

According to the gas laser apparatus in the first embodiment of the invention as above described, since the laser gas generating plasma by the microwave discharge is filled in a space formed between a conductor wall to constitute a part of a microwave circuit and dielectrics installed opposite to the conductor wall and at the same time the microwave circuit forms microwave mode having the electric field component perpendicular to the boundary between the dielectrics and the plasma, the microwave discharge plasma being uniform in space can be generated and the discharge as a whole can be made suitable for the laser excitation and further the laser resonator mode and the plasma can be overlapped well, thereby the gas laser apparatus of high efficiency and large output can be obtained.

Furthermore, since a groove is formed on the conductor to constitute a part of the microwave circuit and an opening portion of the groove is covered by the dielectrics so as to form a space, and a plasma generating medium is filled in the space, filling of the plasma generating medium into the space can be performed easily.

Next, a gas laser apparatus as one of plasma apparatuses according to a second embodiment of the present invention will be described. In the second embodiment, plasma being more uniform in space can be generated by microwave discharge of the pulse microwave.

That is, constitution of the gas laser apparatus in the second embodiment is similar to that of the first embodiment shown in FIGS. 6 and 7. Consequently, the same parts shall be described by designating the same reference numerals.

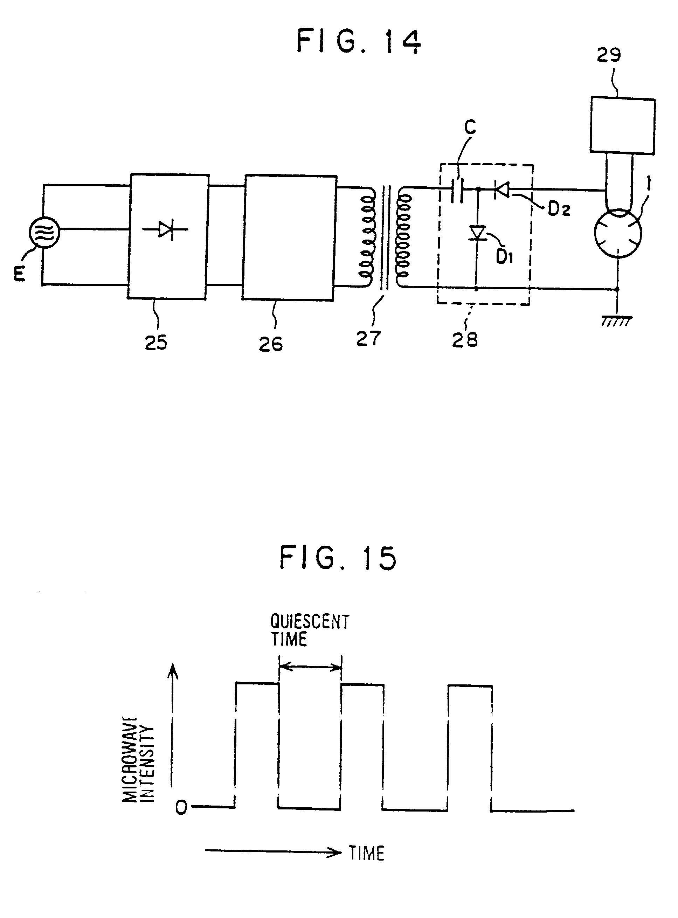

On the other hand, a power source to drive a magnetron 1 is constituted as shown in FIG. 14. In FIG. 14, commercial frequency AC power source E is converted into DC by a rectifying and smoothing circuit 25, and the DC is converted into high-frequency AC such as 20 KHz by a DC-AC inverter circuit 26. The high-frequency AC is stepped up by a transformer 27, and converted into ripple current of high voltage by a half-wave voltage multiplying rectifier circuit 28 constituted by a capacitor C and diodes $D_1$, $D_2$, and then applied to the magnetron 1. Numeral 29 designates a filament power source of the magnetron 1.

Main operation of the gas laser apparatus of the second embodiment constituted as above described is similar to that of the apparatus of the first embodiment. In FIG. 8, in vertical direction to the paper surface of the figure, i.e., in the length direction of discharge, node of discharge is produced corresponding to mode of the microwave.

Also in this embodiment, since the apparatus shown in FIG. 14 is used as the power source of the magnetron being a microwave oscillator to generate microwave, waveform of the microwave generated by the magnetron driven by the power source becomes as shown in FIG. 15. That is, pulse microwave interrupted by high frequency is generated. Pulse duty of the pulse microwave can be made very high value such as 0.1 - 0.4 in comparison to the pulse microwave in the prior art. Consequently, quiescent time of the microwave becomes sufficiently shorter than the thermal time constant of the plasma generating medium, for example, $CO_2$ laser gas. Also the pulse frequency can be made very high such as several tens kHz. When the apparatus in FIGS. 6 - 7 is operated in such manner, it has been confirmed that length of discharge interrupted by the node of the microwave electromagnetic field in the length direction becomes short, and the discharge becomes more uniform also in the length direction. If the pulse frequency is about 500 Hz or more, since the quiescent time of the pulse microwave further becomes shorter than the thermal time constant of the filled plasma generating medium, the time modulation of the plasma parameter is suppressed and the plasma being uniform also in time is generated.

In this case, 2M120 (manufactured by Hitachi, Ltd.) was used as the magnetron 1, and microwave of about 2.45 GHz was generated. The pulse frequency is 20 kHz, and the pulse duty is 0.4. Thus similar results to the graph of FIG. 9 were obtained.

Although the inverter is used as the power source of the magnetron 1 in the embodiment as above described, power source of chopper type to be applied to the magnetron 1 from the DC power source of high voltage through switching element may be used so as to generate the pulse microwave. Moreover, although the laser apparatus is shown as the plasma apparatus in the embodiment, the invention may be applied to an ion source or a light source plasma processing apparatus, and similar effect can be obtained in that the discharge is made uniform in space and in time.

Furthermore, although the conductor and the plasma are contacted with each other in the embodiment as above described, when a thin dielectric layer such as a dielectric coating layer is provided on the conductor surface, since this dielectric layer does not significantly affects the electric field distribution of the microwave, of course, the above-mentioned effect is not deteriorated.

According to the second embodiment of the invention as above described, the plasma generating medium is filled in a space formed between a conductor wall to constitute a part of the microwave circuit in the plasma apparatus and dielectrics installed opposite to the conductor wall, and the microwave circuit forms microwave mode having component being perpendicular to the boundary with the dielectrics and the pulse microwave is excited in the microwave circuit, thereby the plasma being uniform in space can be obtained.

Further in the second embodiment of the invention as above described, since the pulse microwave having the quiescent time shorter than the thermal time constant of the plasma generating medium such as $CO_2$ laser gas is excited in the microwave circuit, the plasma being uniform in space and in time can maintained stably for a long time, and the discharge as a whole can be easily made suitable for the laser excitation, and the laser resonator mode and the plasma can be overlapped well, thereby the $CO_2$ gas laser apparatus to enable the laser operation of high efficiency and large output can be obtained.

Another embodiment of the power source apparatus to supply pulse voltage to a non-linear load such as the magnetron 1 will now be described.

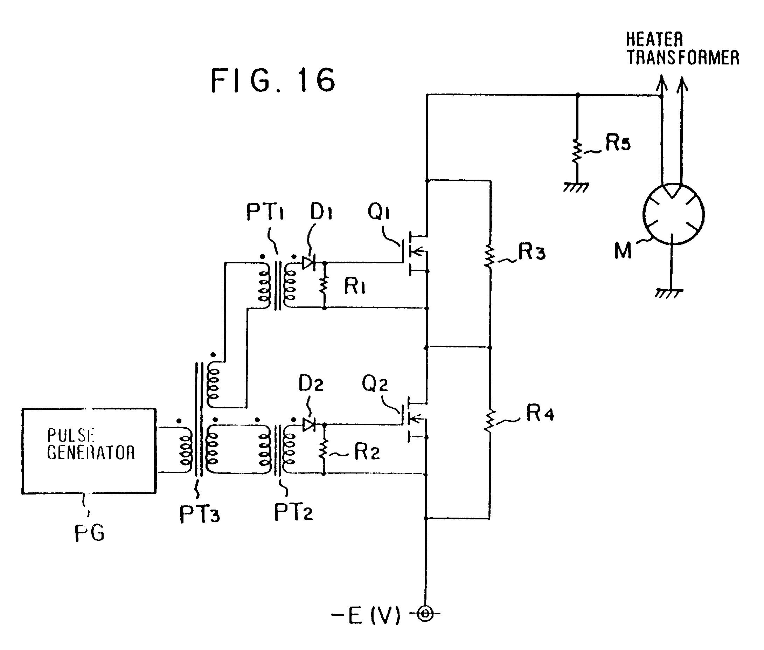

FIG. 16 is a circuit diagram of the power source apparatus. In FIG. 15, M designates a magnetron as a non-linear element, Q1, Q2 designate field effect transistors (hereinafter referred to as "FET") as semiconductor switching element, $PT_1$, $PT_2$, $PT_3$ designate pulse transformers to apply voltage to gate of the FET $Q_1$, $Q_2$, $D_1$, $D_2$ designate reverse-current blocking diodes, $R_3$, $R_4$, $R_5$ designate dividing resistors for high voltage, and PG designates a pulse generator.

Next, operation will be described. When pulse is not applied to the pulse transformer $PT_3$ from the pulse generator PG, the FET $Q_1$, $Q_2$ are turned off. Then, if voltages applied to the FET $Q_1$, $Q_2$ and the magnetron M are made $V_{oQ1}$, $V_{oQ2}$ and $V_{oM}$ respectively and the power source voltage is made -E(V), it follows that

$$V_{oQ1} = -E \frac{R_3}{R_3 + R_4 + R_5} \text{ (V)}, \qquad V_{oQ2} = -E \frac{R_4}{R_3 + R_4 + R_5} \qquad \text{(V)}$$

$$V_{oM} = -E \frac{R_5}{R_3 + R_4 + R_5} \qquad \text{(V)}$$

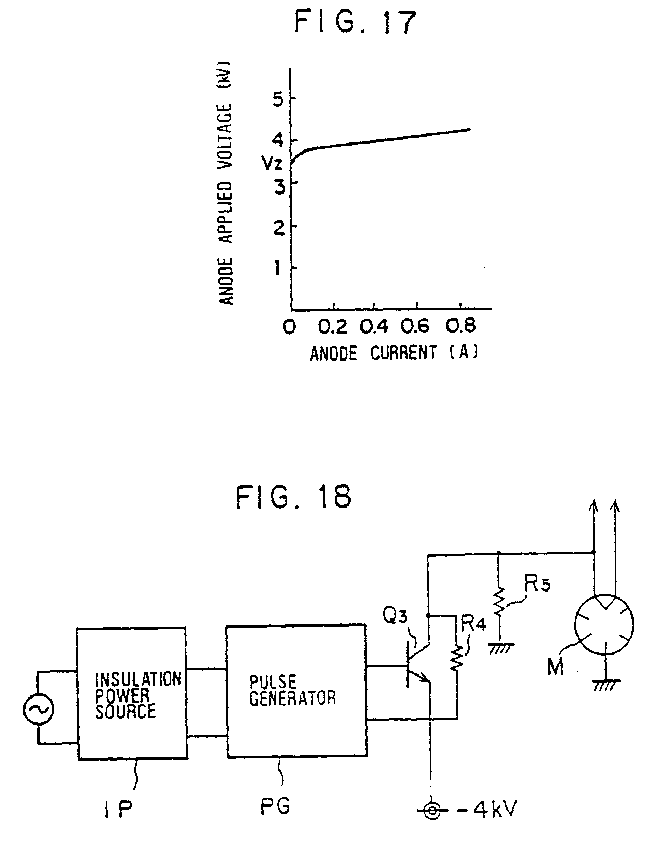

Relation between the anode applied voltage and the anode current in the magnetron M becomes as shown in FIG. 17, and the current does not flow at the cutoff voltage $V_z$ or less. Consequently, if values of the dividing resistors $R_3$ - $R_5$ are determined so that $V_{oM} < V_z$, the magnetron M does not act when the FET $Q_1$ - $Q_2$ are turned off. Further, if the values of the dividing resistors $R_3$ - $R_5$ are determined so that relation of withstand voltage of the FET $Q_1$, $Q_2$ to $V_{DSS}$ (drain-source voltage) becomes $V_{oQ1}$, $V_{oQ2} < V_{DSS}$, since voltage over the withstand voltage is not applied to the FET $Q_1$, $Q_2$ when the FET $Q_1$, $Q_2$ are turned off, the FET $Q_1$, $Q_2$ are not broken.

If pulse is applied to the pulse transformer $PT_3$ from the pulse generator PG, the pulse is applied to gate of the FET $Q_1$, $Q_2$ and therefore the FET $Q_1$, $Q_2$ are turned on. Then since the magnetron M is supplied with the power source voltage -E(V) as it is, the magnetron M acts and microwave is generated. Thus every time pulse is applied to the pulse transformer $PT_3$ from the pulse generator PG, the magnetron M acts and the microwave is generated in pulse form. Since the FET $Q_1$, $Q_2$ are connected to the high voltage circuit, they must be Insulated to the power source of the pulse generator PG. However, if the insulation withstand voltage of the pulse transformers $PT_1$ - $PT_3$ is made E(V) or more, the pulse generator PG is insulated from the high voltage circuit and therefore can be constituted in ordinary power source potential or the ground potential.

In the embodiment of FIG. 16, the two FET $Q_1$, $Q_2$ are connected in series and used as the semiconductor switching element, but the number is determined by the withstand voltage. That is, the withstand voltage of the semiconductor switching element may be made higher than difference (E - $V_z$) (V) between the operation voltage E(V) of the magnetron M and the cutoff voltage $V_z$(V). For example, if $V_z$ = 3.2 kV and E = 4.2 kV, voltage applied to the semiconductor switching element at OFF-state must be set to 1 kV or more. Consequently, since the withstand voltage of the FET should be 1 kV or more, two FET each having the withstand voltage being 500 V or more, preferably 700 - 800 V must be used.

FIG. 18 is a circuit diagram illustrating another embodiment where one bipolar transistor is used as the semiconductor switching element.

In FIG. 18, the same or similar parts to those of FIG. 16 as hereinbefore described are designated by the same reference numerals. In FIG. 18, $Q_3$ designates one transistor as the switching element, and IP designates an insulation power source.

Next, operation will be described. The pulse generator PG drives base of the bipolar transistor $Q_3$ thereby the bipolar transistor $Q_3$ is turned on. Also in this case, in similar manner to FIG. 16, values of the dividing resistors $R_4$, $R_5$ may be set so that voltage applied to the magnetron M becomes $V_z$ or less at OFF-state of the bipolar transistor $Q_3$, and voltage applied to the bipolar transistor $Q_3$ is its withstand voltage or less. Further, although the pulse generator PG is connected directly to the high voltage circuit, if the power source of the pulse generator PG is made the insulation power source IP where high-voltage insulation is performed by the power source transformer, the high voltage circuit and the primary side of the power source are insulated.

In the above-mentioned embodiment, although the magnetron M has been explained as an example of non-linear element, any power source for the non-linear element or device where current does not flow at voltage less than the prescribed voltage $E_z$, and current flows at the prescribed voltage $E_z$ or more can perform similar operation.

According to the power source apparatus of the invention as above described, in the power source apparatus to drive the nonlinear element or device where current does not flow at voltage less than the prescribed voltage $E_z$ and current flows at the prescribed voltage $E_z$ or more, since the semiconductor switching element connected in series to the nonlinear element or device controls current flowing from the voltage source to the nonlinear element or device, the power source of high voltage is not required for the control, and the power source apparatus of small size can be obtained, and further the semiconductor switching element with relatively low withstand voltage may be used.

Next, a gas laser apparatus as a third embodiment will be described. In the third embodiment, the wall surface by the conductor of the space in which the laser gas is filled as shown in the first embodiment is coated with a ceramic layer. Thereby the wall surface of the conductor can be protected, and deterioration of the laser gas can be prevented, and further the laser oscillation at high efficiency and long life becomes possible.

That is, on the wall surface of the conductor including the conductor wall 11 in FIG. 7 of the first embodiment, the ceramic layer 15 is formed by coating. If the ceramic layer 15 is formed in such manner, since the wall surface by the conductor including the conductor wall 11 of the discharge space 13 coated with the ceramic layer 15, the plasma generated by the microwave discharge is not directly contacted with the conductor wall 11 or the like, and the generated plasma is not liable to sputtering and enveloped in the ceramic layer 15 and the dielectrics 12 being inert chemically. Consequently, deterioration of the laser gas due to sputtering or chemical reaction scarcely occurs, and the wall surface by the conductor of the discharge space 13 is not subjected to damage by sputtering, thereby the plasma apparatus such as the gas laser apparatus of microwave excitation system can be realized at high efficiency and long life.

In this case, in order to obtain uniform discharge in space stably, it is necessary that the microwave is incident to the plasma only from one surface thereof. Consequently, it is preferable that thickness of the ceramic layer 15 is sufficiently less than that of the dielectrics 12. When the thickness of the ceramic layer 15 is made 1/10 of that of the dielectrics 12 or less, it has been confirmed that most of the microwave energy is injected from side of the dielectrics 12 of the plasma. Moreover, it is necessary that impedance of the end of the incident microwave is less than impedance of the plasma. When specific dielectric constant of the ceramic layer 15 is made $\varepsilon r$, thickness of the ceramic layer 15 is made d, surge impedance of the vacuum is made $Z_o$, and resistivity of the plasma is made $\delta$, following relation must be satisfied.

$$(d/\varepsilon r) < (\delta/Z_o)$$

Further, in the laser apparatus using the laser gas including halogen gas having high chemical activation, such as an eximer laser apparatus, of course, material which does not react with halogen group should be used as the ceramic layer 15.

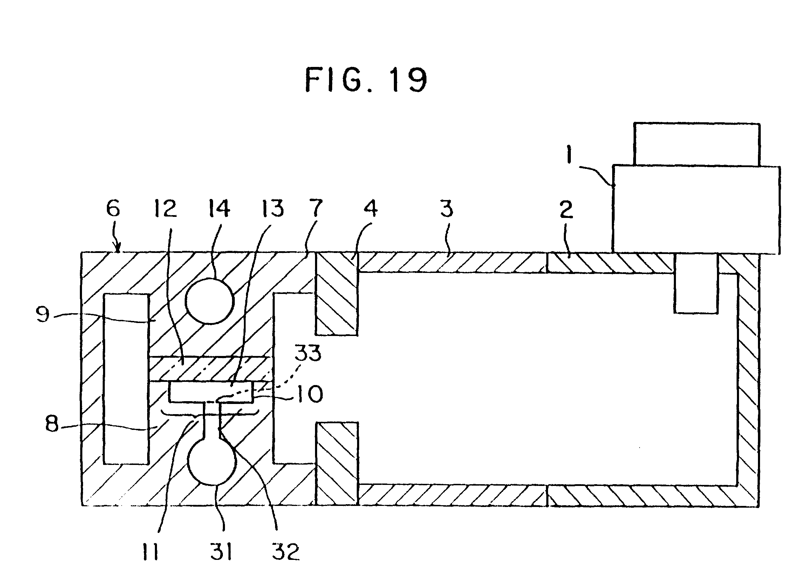

Next, a fourth embodiment will be described according to FIG. 19. In the fourth embodiment, a reservoir tank communicating with the space formed by the conductor wall and the dielectrics is installed, and the plasma generating medium is stored in the reservoir tank, thereby deterioration of the plasma generating medium such as the laser gas is prevented, and the plasma apparatus to enable the plasma operation at high efficiency and large output can be obtained.

FIG. 19 shows constitution of the apparatus. In FIG. 19, common parts to the gas laser apparatus of FIG. 7 are designated by the same reference numerals and the description shall be omitted. In FIG. 19, numeral 31 designates a reservoir tank which is formed in the conductor behind the conductor wall 11 of the ridge 8 for storing the laser gas to replace the laser gas within the discharge space 13, numeral 32 designates one or plural connection penetrating holes to perform communication between the reservoir tank 31 and the discharge space 13, and numeral 33 designates a gas permeable member, for example, by a metal mesh or the like, which is arranged at an opening portion in the discharge space 13 of the connection penetrating hole 32 and makes the laser gas pass and reflects the microwave.

Since the reservoir tank 31 is installed as above described, the laser gas in the discharge space 13 suitably replaces the laser gas in the reservoir tank 31 through the connection penetrating hole 32 and the gas permeable member 33, thereby even if the laser oscillation is performed for a long time, deterioration of the laser gas can be suppressed to minimum and the laser gas is made long life. In this case, since the gas permeable member 33 by the metal mesh or the like is arranged at the opening portion in the discharge space 13 of the connection penetrating hole 32, the microwave mode in the discharge space 13 is not disturbed.

In the embodiment, although the gas permeable member to reflect the microwave and to make the laser gas pass is arranged on end portion at side of the discharge space of the connection penetrating hole, if the connection penetrating hole is of cutoff size or less not to transmit the microwave, the gas permeable member may be omitted and similar effects to that of the above embodiment are obtained.

According to the invention as above described, the plasma generating medium such as laser gas to generate the plasma by the microwave discharge is filled in the space formed between the conductor wall formed on a part of the microwave circuit and the dielectrics installed opposite to the conductor wall, and the plasma generating medium suitably replaces the medium stored in the reservoir tank, and further the microwave circuit forms the microwave mode having the electric field distribution orthogonal to the boundary between the dielectrics and the plasma, the plasma being uniform in space can be stably maintained for a long time and the discharge as a whole can be made suitable for the laser excitation. Further, since deterioration of the plasma producing medium can be prevented without adding a large-scale apparatus at outside for changing the plasma generating medium, the compact plasma apparatus can be obtained at high efficiency, large output and long life.

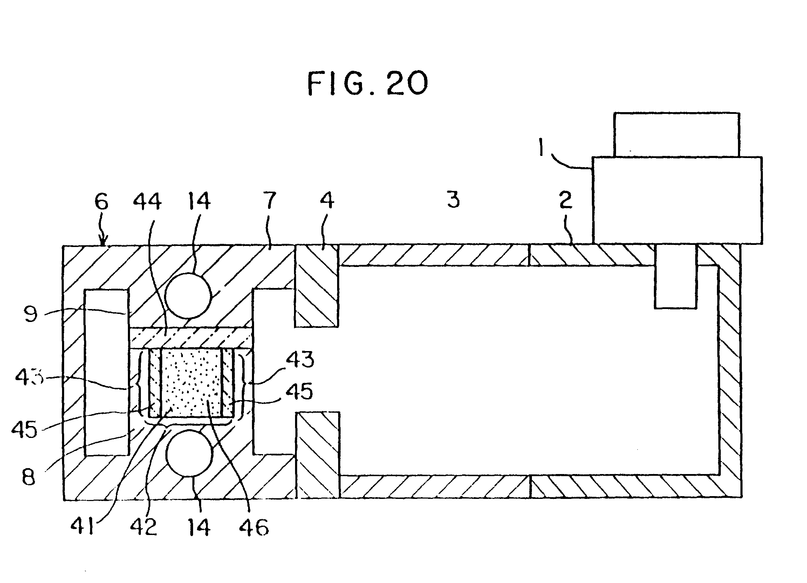

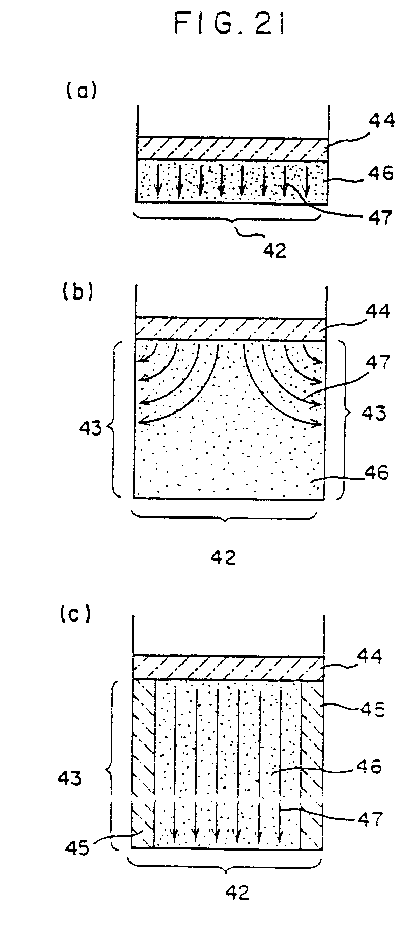

Next, a fifth embodiment of the invention will be described referring to FIG. 20 and FIG. 21. In the fifth embodiment, uniform discharge can be obtained particularly even at the discharge space of large area. FIG. 20 shows the gas laser apparatus according to the fifth embodiment. In FIG. 20, common parts to those in FIG. 7 of the first embodiment are designated by the same reference numerals.

In FIG. 20, numeral 41 designates a recess formed on one ridge 8, numeral 42 designates a conductor wall which constitutes a part of the microwave circuit and forms a bottom surface of the recess 41, and numeral 43 designates a second conductor wall which forms side surface of the recess 41. Numeral 44 designates first dielectrics, for example, by alumina, which covers an opening portion of the recess 41 and is opposite to the first conductor wall 42 and acts as an incident window of microwave. Numeral 45 designates second dielectrics, for example, by alumina, which is arranged on the wall surface of the second conductor wall 43. Numeral 46 designates a discharge space which is formed between the first dielectrics 44 and the second dielectrics 45 when the first conductor wall 42 covers the opening portion of the recess, and in which the plasma generating medium such as $CO_2$ laser gas is filled, and numeral 14 designates a cooling water path formed on the ridge 8 and the ridge 9.

Main part of the laser excitation operation of the fifth embodiment is similar to the case of the first embodiment described in FIG. 7. In this case, microwave discharge is performed in the discharge space 46 having the first conductor wall 42 to constitute a part of the microwave circuit, and the first dielectrics 44 being an incident window of microwave, which is installed opposite to the first conductor wall 42. Since the microwave is incident to the plasma only from one surface thereof, it does not occur that the microwave mode of the coaxial mode using the plasma as inner conductor becomes predominant, and discharge by expected microwave mode can be performed. Also when the microwave circuit forms the microwave mode having the electric field component orthogonal to the boundary between the first dielectrics 44 and the plasma as in the ridge cavity of the laser head section 6 shown in the figure, since the first dielectrics 44 and the first conductor wall 42 are opposite to each other, the electric field component is orthogonal also to the first conductor wall 42 thereby the electric field penetrating the plasma is produced. Consequently, even if the plasma having conductivity is generated, since the first conductor wall 42 having the conductivity higher by several figures than the plasma is installed opposite to the first dielectrics 44 as a microwave incident window, the end current of the incident microwave flows through the first conductor wall 42 and the electric field near the first conductor wall 42 is made forcedly orthogonal to the surface of the first conductor wall 42 thereby the electric field penetrating the generated plasma is maintained. Consequently, the microwave enters into the plasma and the current penetrating the plasma flows and the discharge plasma being uniform in space is generated because of continuity of current.

This applies without problem to the case shown in FIG. 21(a) where the discharge space 46 is small and the distance between the first conductor wall 42 and the first dielectrics 44 is small. However, in order to increase the discharge space 46, if the distance between the first conductor wall 42 and the first dielectrics 44 is increased, impedance of the plasma within the discharge space 46 becomes large, and the electric field component to bypass the second conductor wall 43 is produced as shown in FIG. 21(b). Consequently, the electric line of force 47 becomes predominant in that directed to the second conductor wall 43 rather than that directed to the first conductor wall 42, thereby uniformity of the generated plasma is deteriorated. Consequently, the second dielectrics 45 are arranged between the second conductor wall 43 and the plasma within the discharge space 46, and as shown in FIG. 21(c), the second dielectrics 45 weakens the electric line of force 47 directed to the second conductor wall 43 and strengthens the electric line of force 47 directed to the first conductor wall 42 so that the electric field component orthogonal to the first conductor wall 42 becomes predominant. Thereby the uniform discharge in space is obtained and the discharge as a whole can be easily made suitable for the laser excitation.

In the embodiment, although application to the gas laser apparatus has been described, the invention may be applied to a plasma processing apparatus, an ion source, a light source or the like, and similar effects to the embodiment can be obtained.

According to the invention as above described, the first conductor wall with the bottom surface constituting a part of the microwave circuit, and the second conductor wall as the side surface constitute the recess, and an opening portion of the recess is covered with the first dielectrics, and further the plasma generating medium is filled in the space formed by the second dielectrics arranged on the second conductor wall, and the microwave circuit forms the microwave mode having the electric field component orthogonal to the boundary between the plasma and the first dielectrics, thereby the microwave being uniform in space is stably maintained for a long time even at the discharge space of large area, and the plasma apparatus of large diameter to generate plasma having high uniformity in space can be obtained.

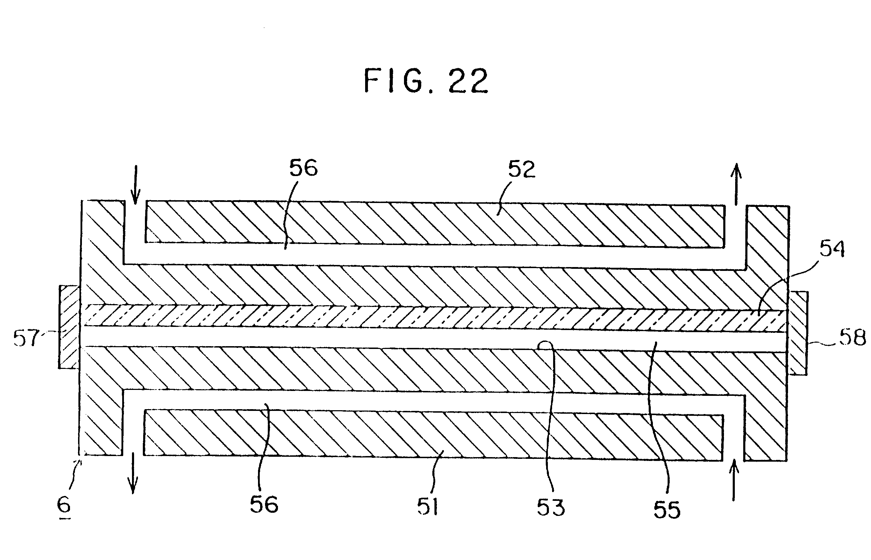

Next, an optical waveguide type gas laser apparatus in plasma apparatuses as a sixth embodiment according to the invention will be described referring to FIG. 22. In this case, a sectional view of the apparatus in the sixth embodiment is the same as the sectional view of the apparatus of the first embodiment described by FIG. 7 and therefore the sixth embodiment shall be described also referring to FIG. 7. FIG. 22 is a sectional view taken along line X-X in FIG. 7. In FIG. 22, numeral 6 designates a laser head section, numerals 51 and 52 designate ridges installed on a cavity wall 7 following a microwave coupling window 4, numeral 53 designates a conductor wall, numeral 54 designates dielectrics as an incident window of microwave opposite to the conductor wall 53, numeral 55 designates a discharge space which is formed between the conductor wall 53 and the dielectrics 54 when the dielectrics 54 cover the groove formed on the ridge 51 and in which the laser gas such as $CO_2$ laser gas is filled, and numeral 56 designates a cooling water path formed on the ridge 51 having the conductor wall 53 constituting a part of the microwave circuit and on the ridge 52 opposite to the ridge 51. Also, numerals 57, 58 designate a total reflection mirror and a partial transmission mirror respectively arranged opposite to each other on both ends of the discharge space 55, and the discharge space 55 acts also as an optical waveguide having dimension suitable to guide the generated laser rays.

Main operation of the optical waveguide type gas laser apparatus is the same as that of the first embodiment described referring to FIGS. 6 - 7. In the sixth embodiment, a cooling water flows in the cooling water path 56 provided on the ridge 51 having the conductor wall 53 constituting a part of the microwave circuit and on the ridge 52 opposite to the ridge 51, and the conductor wall 53 and the dielectrics 54 contacted directly with the laser gas within the discharge space 55 are cooled, thereby the laser gas is cooled efficiently, and saturation of the laser output due to temperature rise of the laser gas is prevented although this becomes a problem particularly in the case of using the $CO_2$ laser gas, and further the optical waveguide type gas laser apparatus can be obtained at high efficiency and large output.

In the embodiment, although the groove is provided on one ridge and the discharge space is formed, the dielectrics provided with the groove may be held on the flat upper surface of the ridge and the discharge space may be formed.

According to the optical waveguide type gas laser apparatus of the invention as above described, the space being an optical waveguide is formed by the conductor wall constituting a part of the microwave circuit and the dielectrics opposite to the conductor wall, and laser gas is filled in the space and the microwave is entered using the dielectrics as a microwave incident window, thereby the laser excitation by the microwave becomes possible. Furthermore, since the conductor wall having conductivity higher than that of the plasma exists opposite to the dielectrics into which the microwave is entered, the end current of the incident microwave flows through the conductor wall and current penetrating between the dielectrics and the conductor wall flows in the plasma, thereby the uniform plasma in space can be stably maintained in the laser gas.

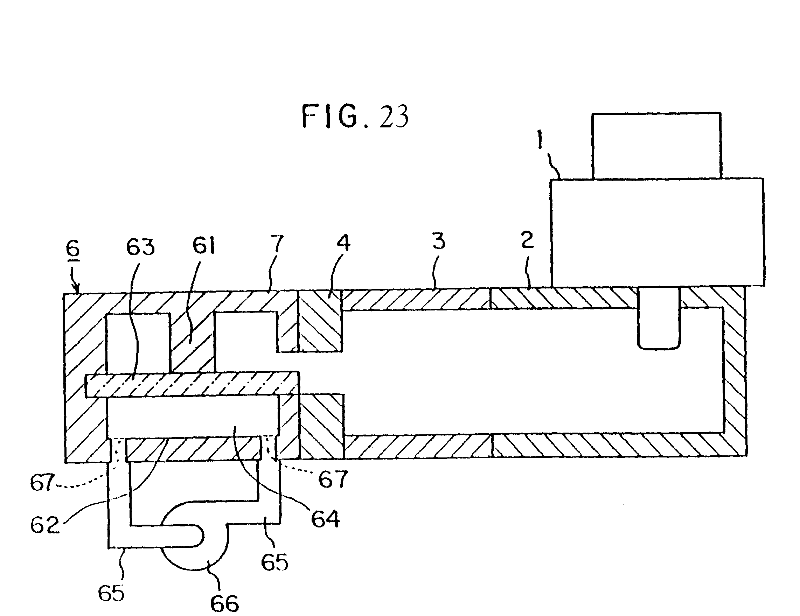

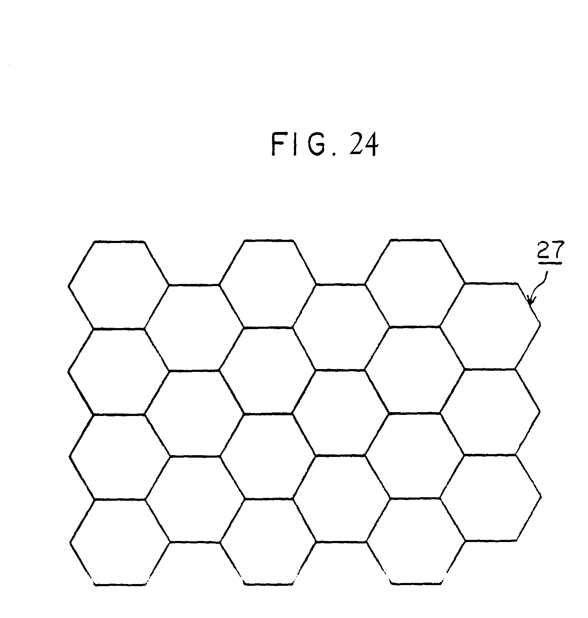

FIGS. 23 through 25 show a seventh embodiment where heat of a laser discharge tube is prevented by circulation means. FIG. 23 is a sectional front view of the gas laser apparatus. An appearance view of the seventh embodiment is the same as that of the first embodiment shown in FIG. 6, and in FIG. 23, common parts to those in the first embodiment are designated by the same reference numerals and the description shall be omitted. In FIG. 23, numeral 6 designates a laser head section having structure of a microwave cavity of ridge waveguide type, numeral 1 designates a magnetron, numeral 2 designates a waveguide, numeral 3 designates a horn waveguide, and numeral 4 designates a microwave coupling window. Numeral 7 designates a cavity wall following the microwave coupling window 4 in the laser head section 6, numeral 61 designates a ridge installed on center portion of the cavity wall 7, and numeral 62 designates a conductor wall constituting a part of the microwave circuit, and in this embodiment, a flat H-surface opposite to the cavity 7 of the microwave circuit of the microwave cavity structure of ridge waveguide type is used as the conductor wall 62. Numeral 63 designates dielectrics, for example, by alumina, which is installed opposite to the conductor wall 62 and acts as a microwave incident window, numeral 64 designates a discharge space which is formed between the conductor wall 62 and the dielectrics 63 and in which the laser gas such as $CO_2$ laser gas is filled, numeral 65 designates a gas feed tube communicating with the discharge space 64, numeral 66 designates a blower as circulation means installed at midway of the gas feed tube 65, and numeral 67 designates a gas permeable member installed at an opening portion of the gas feed tube 65 to the discharge space 64 for reflecting the microwave, and for example, a honeycomb structure of metal as shown in FIG. 24 is used as the gas permeable member 67.

Next, operation will be described. Main operation of the laser excitation is the same as that already described. The blower 66 is operated and the laser gas within the discharge space 64 is circulated and the discharge plasma is cooled, and at the same time the discharge conditions such as pressure of the laser gas are suitably selected thereby the laser oscillation conditions are obtained. Since the gas permeable member 67 by the metal honeycomb structure shown in FIG. 24 is used in the opening portion of the gas feed tube 65 provided on the conductor wall 62, the laser gas passes through it but the microwave is reflected, thereby the microwave mode within the discharge space 64 is not influenced and the forced circulation of the laser gas by the blower 66 becomes possible. As a result, the discharge plasma being uniform in space is generated. Furthermore, since the microwave propagating freely in the dielectrics 63 enters into the plasma uniformly from the boundary between the dielectrics 63 and the plasma, and the microwave discharge is not apt to become the arc discharge essentially even at the electrodeless discharge, and further the dielectrics 63 act as the capacitive distribution balast, the discharge plasma being uniform in space can be obtained also in the transverse direction of the plasma. As a result, the discharge being significantly uniform in space can be realized. Since the uniform discharge in space is obtained in such manner, the discharge as a whole can be easily made suitable for the laser excitation. Since the laser gas is forcedly circulated by the blower 66 and cooled effectively, saturation of the laser output due to temperature rise of the laser gas can be prevented although this becomes a problem particularly when the $CO_2$ gas is used as the laser gas, and in spite of the microwave excitation system, the gas laser apparatus can be obtained at high efficiency and large output.

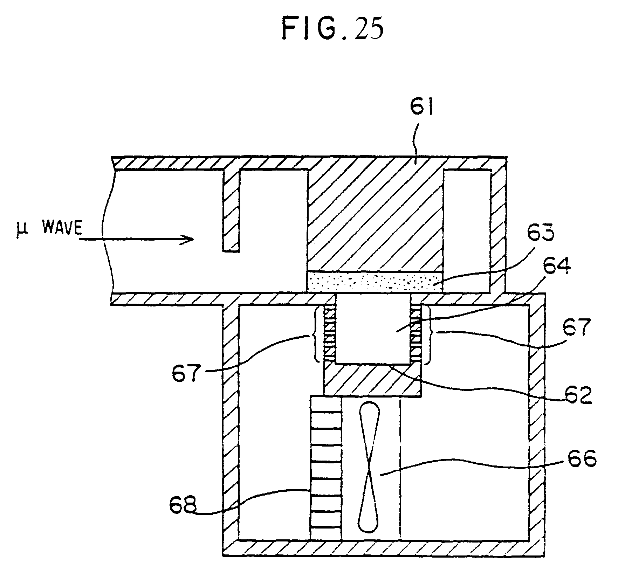

In the embodiment, although the gas permeable member 67 is arranged on the conductor wall 62 to form the bottom surface of the discharge space 64, it may be arranged at side wall portion of the discharge space 64. FIG. 25 is a partial sectional view illustrating the embodiment in such state. In this embodiment, a part of the cavity portion of the microwave circuit acts as the gas feed tube, and at the side wall portion of the discharge space 64 between the conductor wall 62 and the dielectrics 63, the gas permeable member 67 formed by the metal honeycomb structure is arranged where the laser gas can pass but the microwave is reflected. Also in the embodiment, the blower 66 as circulation means is provided with a heat exchanger 68, thereby heat of the circulated laser gas is forcedly radiated to outside and the plasma is cooled more effectively.

In the embodiment, although the honeycomb structure of metal is used as the gas permeable member to reflect the microwave, the gas permeable member may be a conductor with a number of small holes bored thereon, or a metal mesh may be used, and in any case, similar effects to that of the embodiment can be obtained.

According to the embodiment of the invention as above described, since the laser gas is forcedly circulated and cooled by the circulation means, the plasma being uniform in space can be stably maintained for a long time and saturation of the laser output due to temperature rise of the laser gas also can be prevented, thereby the gas laser apparatus to enable laser operation at high efficiency and large output can be obtained.

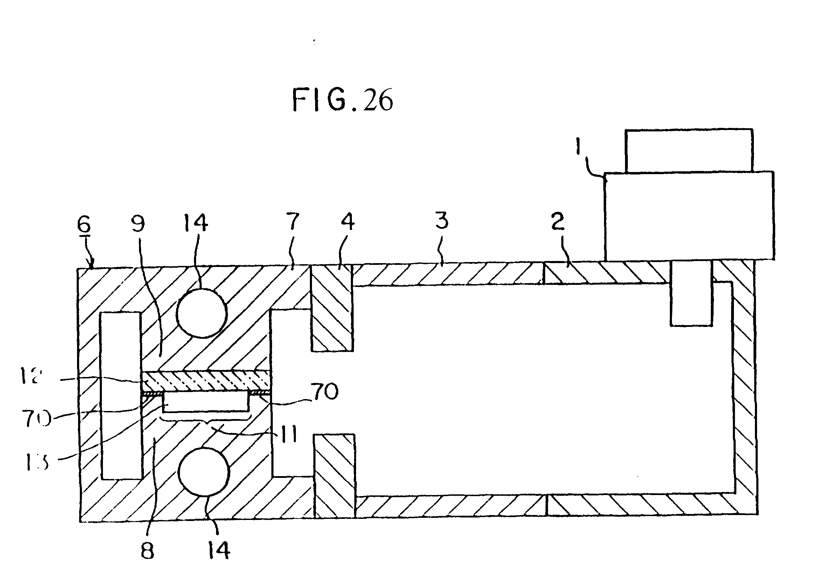

FIGS. 26 through 30 show an eighth embodiment where leakage of the plasma generating medium in the discharge space is prevented by epoxy adhesive agent. In this case, FIG. 26 shows the same apparatus as the gas laser apparatus of the first embodiment shown in FIG. 7. In FIG. 26, numeral 70 designates epoxy adhesive agent which is applied to whole surface of a portion where the dielectrics 12 and the ridge 8 with the conductor wall 11 are contacted with each other and which bonds and seals both members together so that the air tightness of the discharge space 13 is improved. Thereby leakage of the laser gas in the discharge space 13 is sealed completely and the stable laser oscillation can be obtained.

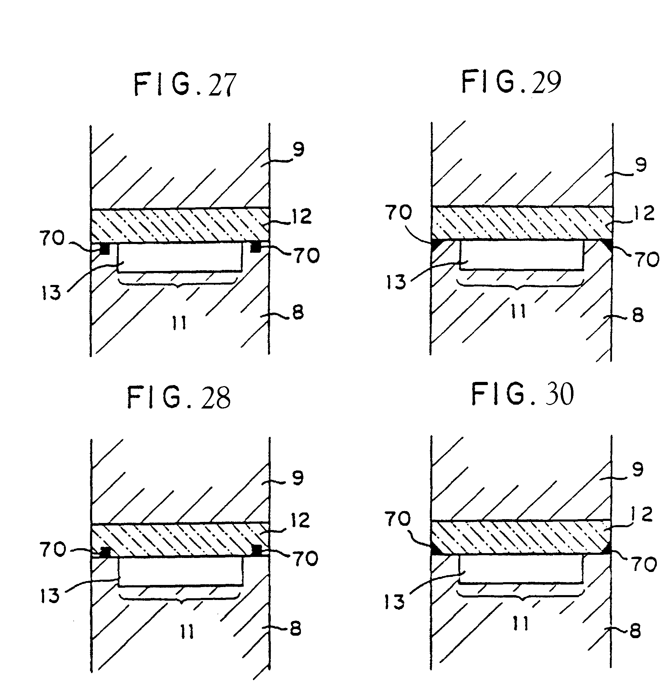

In the embodiment, although whole surface of the contact portion between the ridge 8 and the dielectrics 12 as the microwave circuit is bonded and sealed by the epoxy adhesive agent 70, a part of the contact portion may be bonded and sealed by the epoxy adhesive agent. FIGS. 27 through 30 are partial enlarged sectional views illustrating the embodiment in such state. In FIG. 27, a groove is provided at the contact portion between the ridge 8 and the dielectrics 12, and the epoxy adhesive agent 70 is filled in the groove so as to seal the discharge space 13. In FIG. 28, the groove is provided at side of the dielectrics 12. In FIG. 29, outside edge of the ridge 8 is chamfered, and the epoxy adhesive agent 70 is filled in a triangular groove formed between the ridge 8 and the dielectrics 12. In FIG. 30, the chamfering is performed at outside edge of the dielectrics 12. Thus, as the adhesive agent is filled in the groove, etc., the adhesive agent is not forced out in the discharge space 13, and there is no fear that the adhesive agent emits impure gas being exposed to the discharge.

Furthermore, in place of the epoxy adhesive agent 70, metal seal such as brazing may be applied, and similar effects can be obtained also in this case.

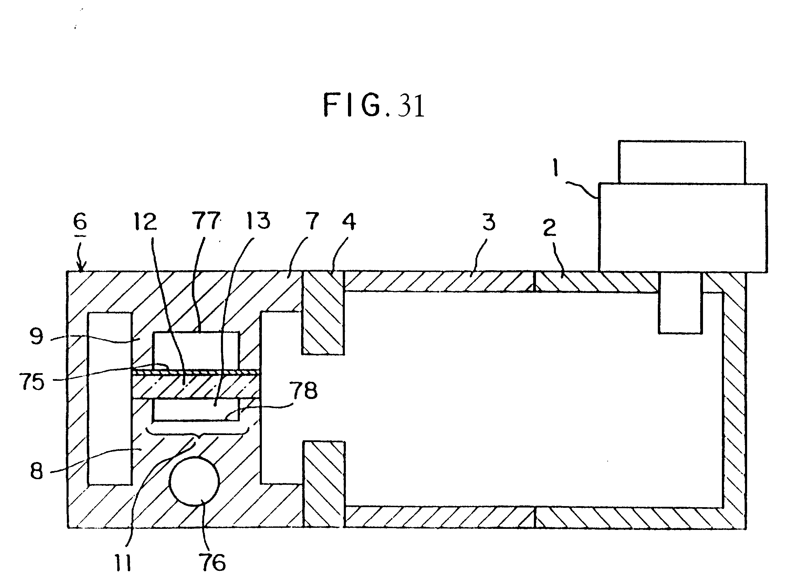

FIG. 31 shows a ninth embodiment where heat of the laser discharge tube can be removed efficiently. In FIG. 31, common parts to those in FIG. 7 of the first embodiment are designated by the same reference numerals. In FIG. 31, numeral 75 designates a metallized layer provided on surface of the dielectrics 12 at reverse side to the discharge space 13, and the metallized layer 75 is formed, for example, by an aluminium evaporation layer and connected integrally to the dielectrics 12. Numerals 76, 77 designate cooling water paths formed respectively on the ridges 8 and 9, and the cooling water path 76 has circular cross-section and the cooling water path 77 has rectangular cross-section. The surface of the metallized layer 75 faces directly to the cooling water path 77, and the dielectrics 12 are contacted directly to the cooling water through the metallized layer 75 and cooled. Numeral 78 designates a groove.

Operation in laser excitation of the embodiment is the same as that already described. The metallized layer 75 is installed integrally at close contact to the surface of the dielectrics 12 at reverse side to the discharge space 13 as above described, and the metallized layer 75 faces to the cooling water path 77 and is contacted directly to the cooling water, thereby the dielectrics 12 are directly cooled and the plasma generating medium such as $CO_2$ laser gas in the discharge space 13 can be cooled efficiently. The temperature rise of the $CO_2$ laser gas or the like which may cause saturation of the laser output is prevented, and the plasma apparatus with high efficiency and large output, for example, the $CO_2$ gas laser apparatus can be provided. Also in this case, the microwave can be absorbed by the

EP 0 674 471 B1

cooling water, and escape of the microwave to outside can be prevented.

According to the invention as above described, since the cooling water in the cooling water path is contacted directly to the metallized layer provided integrally on the dielectrics, temperature rise of the $CO_2$ laser gas can be suppressed effectively and saturation of the laser output can be prevented, thereby the apparatus can be operated with high efficiency even at high discharge power density.

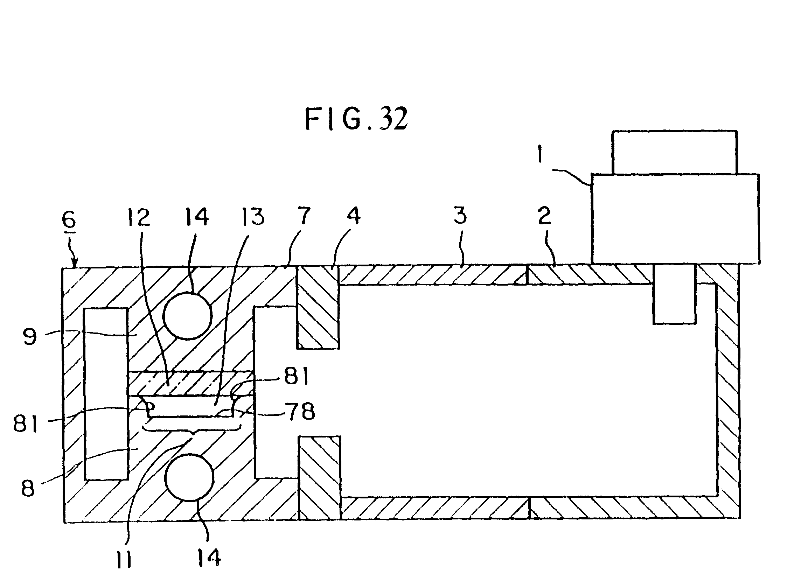

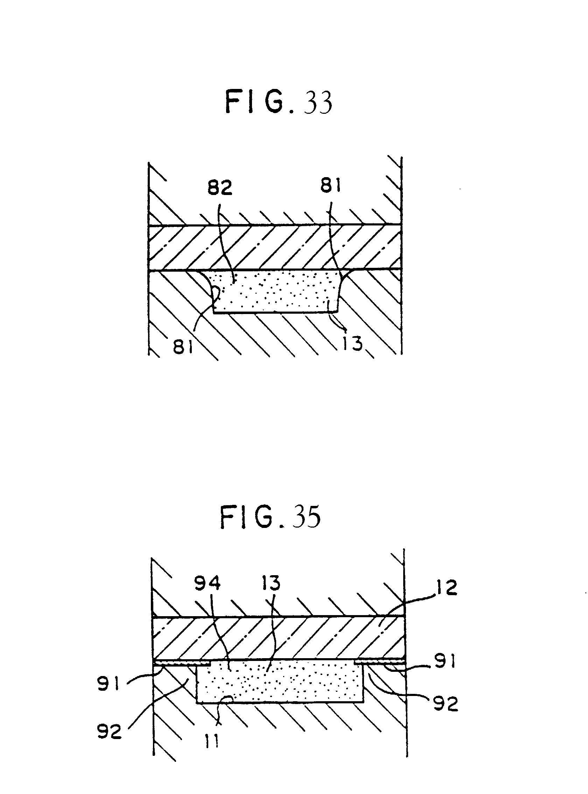

FIG. 32 and FIG. 33 show a tenth embodiment where generation of uneven plasma can be prevented more effectively. FIG. 32 shows the same apparatus as the gas laser apparatus shown in FIG. 7. In FIG. 32, numeral 81 designates an opening edge of a groove 78 to constitute the discharge space 13. The opening edge 81 as shown also in FIG. 33 has a smooth arc-shaped surface so that concentration of the electric field to this portion is prevented.

Consequently, when the plasma is generated and the laser medium is excited, since the opening edge 81 of the groove 78 to constitute the discharge space 13 has the smooth arc-shaped surface as shown in FIG. 33, there is no edge portion to cause concentration of the electric field to the conductor wall 11, thereby uneven plasma due to the concentration of the electric field can be prevented. That is, according to the arc-shaped surface as shown in FIG. 33, generation of the uniform microwave discharge plasma 82 in the discharge space 13 is facilitated, the discharge as a whole is made suitable for the laser excitation, the laser resonance mode and the plasma are overlapped well, and the laser output operation with high efficiency and large output becomes possible.

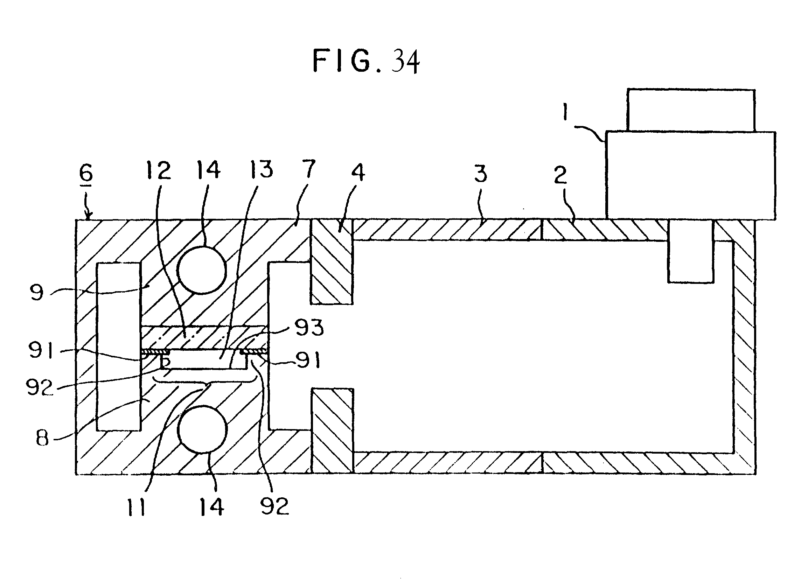

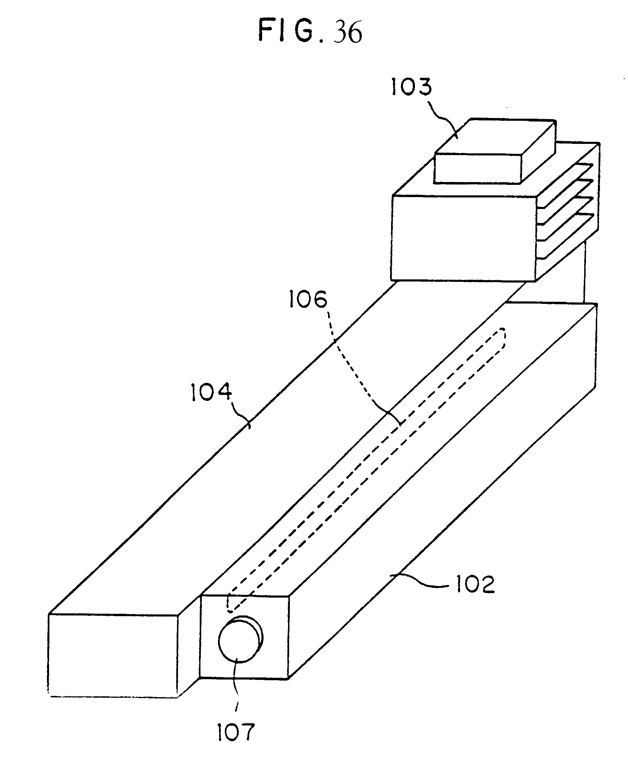

FIG. 34 and FIG. 35 show an eleventh embodiment as a modification of the tenth embodiment hereinbefore described in FIG. 32 and FIG. 33. In FIG. 34, numeral 91 designates a metallized layer, for example, an aluminium evaporation layer, which is provided integrally with a portion on the dielectrics 12 to cover an opening edge portion 92 of the discharge space as clearly seen in FIG. 35. The metallized layer 91 acts to shield the electric field of the microwave so that concentration of the electric field to the opening edge portion 92 is prevented.

Since the metallized layer 91 is provided on a portion of the dielectrics 12 to cover the opening edge portion 92 of a groove 93 to form the discharge space 13, the electric field of the microwave can be shielded although it may be concentrated to the opening edge portion 92 without the metallized layer 91. Consequently, the uneven plasma due to the concentration of the electric field can be prevented. Thus generation of the uniform microwave discharge plasma 94 in the discharge space 13 is facilitated, the discharge as a whole is made suitable for the laser excitation, the laser resonance mode and the plasma are overlapped well, and the laser output operation with high efficiency and large output becomes possible.

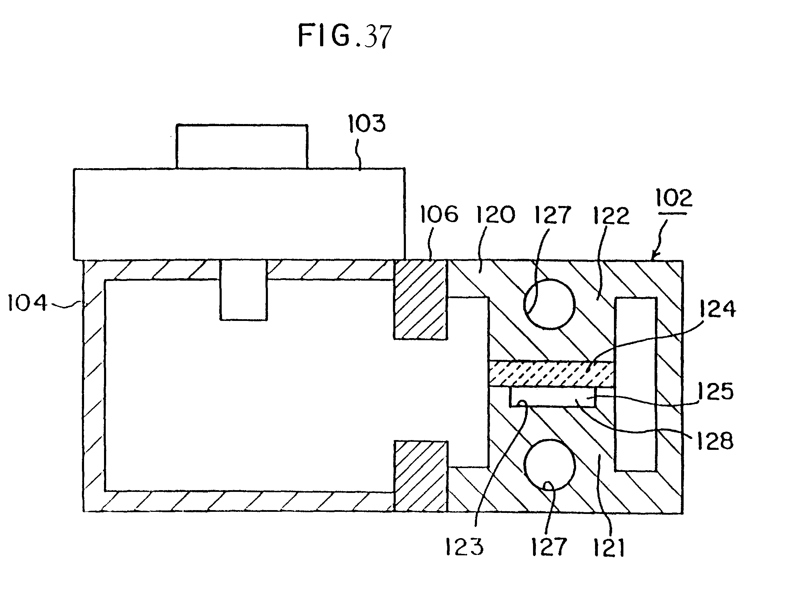

FIGS. 36 through 39 show still other embodiments. In a gas laser apparatus as a twelfth embodiment shown in FIG. 36 and FIG. 37, numeral 102 designates a laser head section having microwave cavity structure of ridge waveguide type, numeral 103 designates a magnetron, numeral 104 designates a waveguide, numeral 106 designates a microwave coupling window which couples the waveguide 104 to the laser head section 102, and numeral 107 designates a reflection mirror for laser oscillation which is mounted on the laser head section 102. Also numeral 120 designates a cavity wall following the microwave coupling window 106 in the laser head section 102, numerals 121 and 122 designate ridges provided on center portion of the cavity wall 120 and constituting a part of the microwave circuit, and numeral 123 designates a conductor wall formed on one ridge 121, and in the embodiment a bottom wall surface of a groove 128 provided on an upper surface of the ridge 121 is used as the conductor wall 123. Numeral 124 designates dielectrics, for example, by alumina, which is installed opposite to the conductor wall 123 and acts as an incident window of microwave, and numeral 125 designates a discharge space which is formed between the conductor wall 123 and the dielectrics 124 when the dielectrics 124 cover the groove 128 on the upper surface of the ridge 121 and in which the laser gas such as $CO_2$ laser gas is filled.

Operation in laser operation of the embodiment is the same as that described in FIG. 7. In the embodiment, the laser head section 102 being the microwave circuit and the waveguide 104 being the microwave transmission path are arranged in parallel in direction along the laser optical axis, and microwave is supplied through the lengthy microwave coupling window 104 provided in the longitudinal direction of the laser head section 102, thereby the strong microwave electromagnetic field can be generated uniformly throughout the whole ridges 121, 122 of the laser head section 102. Consequently, the whole apparatus need not be made large but the long and uniform discharge can be obtained in the laser optical axis and optimum state for the whole discharge and laser excitation is realized.

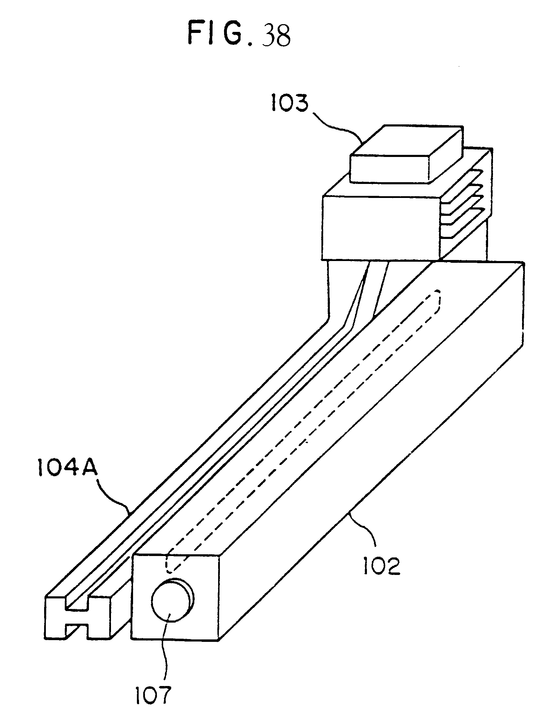

FIG. 38 shows a thirteenth embodiment as a modification of the above-mentioned embodiment. In a gas laser apparatus of this embodiment, in order to avoid state that the waveguide 104 is made of square cross-section and therefore becomes large for the microwave transmission, the waveguide as the microwave transmission path is made a ridge waveguide 104A. Thereby the microwave transmission path can be miniaturized and the whole configuration of the gas laser apparatus is suppressed to small size and the installation occupied space can be reduced.

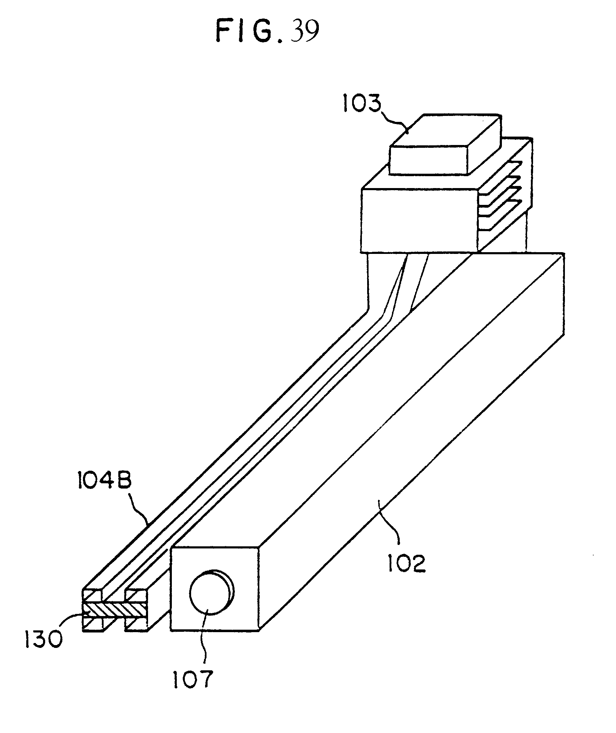

FIG. 39 shows further a fourteenth embodiment of the invention. In this embodiment, a delay waveguide 104B being a delay transmission path is used as a waveguide, and a dielectric plate 130 as delay medium is internally installed. That is, wavelength of microwave passing through dielectrics in the microwave circuit is shorter than value in the case of passing through the vacuum. On the other hand, wavelength of microwave passing through the microwave transmission path such as an ordinary waveguide is longer than value in the case of passing through the vacuum.

14

Consequently, wavelength in each tube of the waveguide as the microwave transmission path and the microwave circuit is not coincident, thereby it is difficult to perform the long and uniform discharge in the laser optical axis direction stably. In this embodiment, in order to solve inconsistency of the wavelength, the microwave transmission path is made a delay waveguide 104B having a dielectric plate 130. Thereby two microwave modes are coincident and the stable and uniform discharge and the laser output operation can be realized.

In the embodiment, although the microwave coupling window 106 is of lengthy slit form, plural holes may be arranged in the laser optical axis direction. In this case, if size of holes is gradually decreased in three directions of the magnetron, that is, if the energy density distribution of the microwave is arbitrarily adjusted, the microwave can be uniformly distributed throughout the whole length of the ridges 121, 122, and uniform discharge in the discharge space 125 can be realized stably, and laser output with high efficiency becomes possible. In the embodiment, although the energy density distribution of the microwave and the impedance matching are adjusted simultaneously by the above-mentioned slit or hole, element for impedance matching may be separately installed and such slit or hole may be installed in other member except for impedance matching.

According to the invention as above described, since laser gas generating plasma by microwave discharge is filled in the discharge space formed between a conductor wall formed in a part of the microwave circuit and dielectrics installed opposite to the conductor wall, and microwave mode having the electric field component orthogonal to the boundary between the dielectrics and the plasma is formed by the microwave circuit, current penetrating between the dielectrics and the conductor wall can flow substantially uniformly within the plasma, thereby the plasma being uniform in space is generated and the laser output can be obtained at high efficiency and large output. Moreover, since the microwave circuit and the microwave transmission path are arranged in parallel in the laser optical axis direction, the long and uniform discharge in the laser optical axis direction becomes possible, and the more stable and uniform plasma can be generated in the discharge space, and further the gas laser apparatus can be miniaturized.

## Claims

1.  A plasma apparatus comprising

    a microwave oscillator (1; 103) for generating microwaves,
    a microwave circuit (6; 102) for generating a plasma (18; 22; 82; 94) by microwave discharge within the microwave circuit (6; 102), and
    a transmission path (2, 3; 104) for transmitting the microwaves from the microwave oscillator (1; 103) to the microwave circuit (6; 102),
    where a plasma generating medium for generating the plasma (18; 22; 82; 94) is filled in a space (13; 46; 55; 64; 125) formed between a conductor wall (11; 42, 43; 53; 62; 123) and dielectrics (12; 44; 54; 63; 124) installed opposite to the conductor wall (11; 42, 43; 53; 62; 123), and
    the microwave circuit (6; 102) is arranged for coupling main energy of the microwaves onto the dielectrics (12; 44; 54; 63; 124) such that a pregiven microwave mode propagates through the boundary existing between the dielectrics (12; 44; 54; 63; 124) and the plasma (18; 22; 82; 94),

    characterized in that

    the microwave oscillator (1; 103) is an oscillator for generating microwaves pulsed by a pregiven pulse frequency, and
    the dielectrics (12; 44; 54; 63; 124) and the conductor wall (11; 42, 43; 53; 62; 123) are configured such that the electric field component (17; 47) of said microwave mode is orthogonal to that part of the boundary through which the microwaves invade the plasma (18; 22; 82; 94).

2.  A plasma apparatus according to claim 1,
    characterized in that the plasma generating medium is $CO_2$ laser gas.

3.  A plasma apparatus according to claim 1 or 2,
    characterized in that a groove (10; 78; 93; 128) is formed on the conductor to constitute a part of the microwave circuit, and the plasma generating medium is filled in a space (13; 125) formed by covering an opening portion (81; 92) of the groove (10; 78; 93; 128)using the dielectrics (12; 124) as an incident window of microwave.

4.  A plasma apparatus according to one of the preceeding claims,
    characterized in that the wall surface of the conductor in the space (13) is coated by a ceramic layer (15).

**5.** A plasma apparatus according to one of the preceeding claims,
characterized in that a reservoir tank (31) communicates with the space (13) by one or more connection penetrating holes (32) and stores the plasma generating medium to be replaced for the plasma generating medium in the space (13).

**6.** A plasma apparatus according to claim 5,
characterized in that the connection penetrating holes (32) are provided with a gas permeable member (33) which reflects the microwave to end at side of the space (13).

**7.** A plasma apparatus according to one of the preceeding claims,
characterized in that a recess (41) comprising a first conductor wall (42) to constitute a part of the microwave circuit as a bottom surface and a second conductor wall (43) as a side surface is installed, an opening portion of the recess (41) is covered by a first dielectric body (44) being an incident window of microwave, a second dielectric body (45) is arranged on the second conductor wall (43), the plasma producing medium is filled in a space (46) formed by the first conductor wall (42), the first dielectric body (44) and the second dielectric body (45), and the microwave circuit (6) forms microwave mode having the electric field component (47) orthogonal to the boundary between the first dielectric body (44) and the plasma generated in the plasma producing medium.

**8.** A plasma apparatus according to one of the preceeding claims,
characterized in that the space (55) formed between the conductor wall (53) and the dielectrics (54) acts as an optical waveguide, the laser gas is filled in the space (13; 46; 55; 64; 125), the microwave is entered using the dielectrics (54) as a microwave incident window, and microwave mode having the electric field component orthogonal to the boundary between the dielectrics (54) and the plasma generated in the laser gas is formed thereby an optical waveguide type gas laser apparatus is constituted.

**9.** A plasma apparatus according to one of the preceeding claims,
characterized in that a part of the space (13; 64) other than the dielectrics (12; 63) is made a gas permeable member (33; 67) to reflect the microwave, and the laser gas in the space (13; 64) is circulated by circulation means through the gas permeable member (33; 67).

**10.** A plasma apparatus according to one of the preceeding claims,
characterized in that the microwave transmission path (2, 3; 104) and the microwave circuit (6; 102) are arranged in parallel along the optical axis.

**11.** A plasma apparatus according to one of the preceeding claims,
characterized in that the microwave is pulsed with a pulse frequency of 500 Hz or more.

**12.** A plasma apparatus according to claim 11,
characterized in that DC is converted into AC having frequency higher than the commercial frequency by an DC-AC inverter (26), and stepped up by a transformer (27), and then pulsed microwave is generated by a microwave oscillator (1) driven by a power source (29) to generate high voltage in ripple by a half-wave voltage multiplying circuit (28).

**13.** A plasma apparatus according to claim 11 or 12,
characterized in that the pulsed microwave is generated by a microwave oscillator (1) driven by a high-voltage pulse source where DC of high voltage is interrupted by a switching element.

**14.** A plasma apparatus according to one of claims 11 to 13,
characterized in that the pulsed microwave has a quiescent time less than the thermal time constant of the plasma generating medium.

**15.** A plasma apparatus according to one of claims 11 to 14,
characterized in that the power source apparatus to supply pulse voltage to the microwave oscillator is a power source apparatus to drive a non-linear element or device (M) where current does not flow at voltage less than the prescribed voltage $E_Z$ and current flows at the prescribed voltage $E_Z$ or more, and a semiconductor switching element ($Q_1$, $Q_2$; $Q_3$) to control power source flowing from voltage source to the non-linear element or device (M) is connected in series to the non-linear element or device (M).

16. A plasma apparatus according to claim 15,
characterized in that the non-linear element or device (M) is provided with dividing resistors ($R_3$, $R_4$, $R_5$) connected in parallel.

17. A plasma apparatus according to claim 15 or 16,
characterized in that the semiconductor switching element ($Q_1$, $Q_2$; $Q_3$) has a withstand voltage being lower than voltage $E_o$ of the voltage source and higher than $E_o$ - $E_z$.

18. A plasma apparatus according to one of claims 15 to 17,
characterized in that a plurality of semiconductor switching elements ($Q_1$, $Q_2$; $Q_3$) are connected in series.

19. A plasma apparatus according to one of claims 15 to 18,
characterized in that the semiconductor switching element ($Q_1$, $Q_2$; $Q_3$) is a field effect transistor ($Q_1$, $Q_2$).

20. A plasma apparatus according to one of claims 15 to 18,
characterized in that the semiconductor switching element ($Q_1$, $Q_2$; $Q_3$) is a bipolar transistor ($Q_3$).

21. A plasma apparatus according to one of claims 11 to 20,
characterized in that the non-linear element (M) is a magnetron.

## Patentansprüche

1. Plasmavorrichtung mit

einem Mikrowellenoszillator (1; 103) zur Erzeugung von Mikrowellen,
einem Mikrowellenkreis (6; 102) zur Erzeugung eines Plasmas (18; 22; 82; 94) mittels Mikrowellenentladung in dem Mikrowellenkreis (6; 102), und
einer Übertragungsstrecke (2, 3; 104) zur Übertragung der Mikrowellen von dem Mikrowellenoszillator (1; 103) zu dem Mikrowellenkreis (6; 102),
wobei ein plasma-erzeugendes Medium zur Erzeugung des Plasmas (18; 22; 82; 94) in einen Raum (13; 46; 55; 64; 125) zwischen einer Leiterwand (11; 42; 43; 54; 62; 123) und einem Dielektrikum (12; 44; 54; 63; 124), das gegenüber der Leiterwand (11; 42; 43; 53; 62; 123) angeordnet ist, gefüllt wird, und
der Mikrowellenkreis (6; 102) den Hauptteil der Mikrowellen derart auf die Dielektrika (12; 44; 54; 63; 124) koppelt, daß eine vorgegebene Mikrowellenmode durch die Grenzfläche zwischen dem Dielektrikum (12; 44; 54; 63; 124) und dem Plasma (18; 22; 82; 94) dringt,

dadurch gekennzeichnet, daß der Mikrowellenoszillator (1; 103) ein Oszillator zur Erzeugung von mit einer vorgegebenen Pulsfrequenz gepulsten Mikrowelle ist, und daß das Dielektrikum (12; 44; 54; 63; 124) und die Leiterwand (11; 42, 43; 53; 62; 123) derart angeordnet sind, daß die elektrische Feldkomponente (17; 47) der Mikrowellenmode senkrecht zu demjenigen Teil der Grenzfläche ist, durch den die Mikrowellen in das Plasma (18; 22; 82; 94) eindringen.

2. Plasmavorrichtung nach Anspruch 1,
dadurch gekennzeichnet, daß das plasma-erzeugende Medium ein $CO_2$-Lasergas ist.

3. Plasmavorrichtung nach Anspruch 1 oder 2,
dadurch gekennzeichnet, daß eine Nut (10; 78; 93; 128) auf dem Leiter ausgebildet ist und einen Teil des Mikrowellenkreises. darstellt, und daß das plasma-erzeugende Medium in einen Raum (13; 125) gefüllt ist, der durch Abdeckung des offenen Abschnitts (81; 92) der Nut (10; 78; 93; 128) gebildet wird, wobei das Dielektrikum (12; 124) als ein Eintrittsfenster für die Mikrowellen dient.

4. Plasmavorrichtung nach einem der vorstehenden Ansprüche,
dadurch gekennzeichnet, daß die Wandoberfläche des Leiters in dem Raum (13) mit einer keramischen Schicht (15) beschichtet ist.

5. Plasmavorrichtung nach einem der vorstehenden Ansprüche,
dadurch gekennzeichnet, daß ein Vorratstank (31) mit dem Raum (13) durch ein oder mehrere Verbindungslöcher (32) in Verbindung steht und das plasma-erzeugende Medium speichert, das gegen das plasma-erzeugende Medium in dem Raum ersetzt werden soll.

**6.** Plasmavorrichtung nach Anspruch 5,
dadurch gekennzeichnet, daß die durchgehenden Verbindungslöcher (32) mit einem gaspermeablen Element versehen sind, welches die Mikrowellen an seinem Ende zum Raum (13) hin reflektiert.

**7.** Plasmavorrichtung nach einem der vorstehenden Ansprüche,
dadurch gekennzeichnet, daß eine Ausnehmung (41) vorgesehen ist, welche eine erste Leiterwand (42) zur Bildung eines Teils des Mikrowellenkreises als eine untere Oberfläche, und eine zweite Leiterwand (43) als eine seitliche Oberfläche umfaßt, daß ein Öffnungsabschnitt der Ausnehmung (41) durch einen ersten dielektrischen Körper (44) abgedeckt ist, der ein Eintrittsfenster für Mikrowellen darstellt, daß ein zweiter dielektrischer Körper (45) an der zweiten Leiterwand (43) angeordnet ist, daß das plasma-erzeugende Medium in einem Raum (46) gefüllt wird, der durch die erste Leiterwand (42) den ersten dielektrischen Körper (44) und den zweiten dielektrischen Körper (45) gebildet wird, und daß der Mikrowellenkreis (6) eine Mikrowellenmode bildet, deren elektrische Feldkomponente senkrecht zu der Grenzfläche zwischen dem ersten dielektrischen Körper (47) und dem in dem plasma-erzeugenden Medium erzeugten Plasma ist.

**8.** Plasmavorrichtung nach einem der vorstehenden Ansprüche,
dadurch gekennzeichnet, daß der Raum (55) zwischen der Leiterwand (53) und dem Dielektrikum (54) als optischer Wellenleiter wirkt, daß das Lasergas in den Raum (13; 46; 55; 64; 125) geführt wird, daß Mikrowellen eintreten, indem das Dielektrikum (54) als Mikrowelleneintrittsfenster benutzt wird, und daß eine Mikrowellenmode mit der elektrischen Feldkomponente senkrecht zur Grenzfläche zwischen dem Dielektrikum und dem im Lasergas erzeugten Plasma aufgebaut wird, wodurch eine Gaslaser-Vorrichtung vom Typ eines optischen Wellenleiters gebildet wird.

**9.** Plasmavorrichtung nach einem der vorstehenden Ansprüche,
dadurch gekennzeichnet, daß ein Teil des Raumes (13; 64) mit Ausnahme des Dielektrikums (12; 63) als gaspermeables Element zur Reflexion der Mikrowellen ausgebildet ist, und das Lasergas in dem Raum (13; 64) durch Zirkulationsmittel durch das gaspermeable Element (33; 67) zirkuliert.

**10.** Plasmavorrichtung nach einem der vorstehenden Ansprüche,
dadurch gekennzeichnet, daß die Mikrowellenübertragungsstrecke (2, 3; 104) und der Mikrowellenkreis (6; 102) parallel zur optischen Achse verlaufen.

**11.** Plasmavorrichtung nach einem der vorstehenden Ansprüche,
dadurch gekennzeichnet, daß die Mikrowellen mit einer Pulsfrequenz von 500 Hz oder mehr gepulst sind.

**12.** Plasmavorrichtung nach Anspruch 11,
dadurch gekennzeichnet, daß mittels eines DC-AC Wechselrichters (26) Gleichstrom in Wechselstrom mit einer Frequenz konvertiert wird, die größer ist als die Netzfrequenz, und mittels eines Transformators (27) hochgespannt wird, und daß dann gepulste Mikrowellen von einem Mikrowellenkreis (1) erzeugt werden, der von einer Spannungsquelle (29) gespeist wird, welche Hochspannung mittels eines Halbwellen-Spannungsmultiplikatorkreises (28) erzeugt.

**13.** Plasmavorrichtung nach Anspruch 11 oder 12,
dadurch gekennzeichnet, daß die gepulsten Mikrowellen an einem Mikrowellenoszillator (1) erzeugt werden, der von einem Hochspannungs-Pulsgenerator ausgesteuert wird, bei dem eine hohe Gleichspannung durch ein Schaltelement unterbrochen wird.

**14.** Plasmavorrichtung nach einem der Ansprüche 11 bis 13,
dadurch gekennzeichnet, daß die gepulsten Mikrowellen eine Auszeit haben, die kleiner als die thermische Zeitkonstante des plasma-erzeugenden Mediums ist.

**15.** Plasmavorrichtung nach einem der Ansprüche 11 bis 14,
dadurch gekennzeichnet, daß das Speisegerät, welches eine Pulsspannung dem Mikrowellenoszillator zuführt, ein Speisegerät ist, welches ein nichtlineares Element oder eine nichtlineare Vorrichtung (M) treibt, bei dem unterhalb einer vorgegebenen Spannung $E_Z$ kein Strom fließt, und bei dem oberhalb einer vorgegebenen Spannung

$E_Z$ Strom fließt, und daß ein Halbleiterschaltelement ($Q_1$, $Q_2$; $Q_3$) zur Steuerung der von der Spannungsquelle zum nichtlinearen Element oder nichtlinearen Element fließenden Speiseleistung in Serie mit dem nichtlinearen Element oder der nichtlinearen Vorrichtung (M) geschaltet ist.

16. Plasmavorrichtung nach Anspruch 15,
dadurch gekennzeichnet, daß das nichtlineare Element oder die nichtlineare Vorrichtung (M) mit parallel geschalteten Teilerwiderständen ($R_3$, $R_4$, $R_5$) versehen ist.

17. Plasmavorrichtung nach Anspruch 15 oder 16,
dadurch gekennzeichnet, daß das Halbleiterschaltelement ($Q_1$, $Q_2$; $Q_3$) eine Schwellspannung aufweist, die kleiner ist als die Spannung $E_0$ der Spannungsquelle und größer als $E_0 - E_z$.

18. Plasmavorrichtung nach einem der Ansprüche 15 bis 17,
dadurch gekennzeichnet, daß mehrere Halbleiterschaltelemente $Q_1$, $Q_2$; $Q_3$) in Serie zueinander geschaltet sind.

19. Plasmavorrichtung nach einem der Ansprüche 15 bis 18,
dadurch gekennzeichnet, daß die Halbleiterschaltelemente ($Q_1$, $Q_2$; $Q_3$) als Feldeffekttransistor ($Q_1$, $Q_2$) ausgebildet sind.

20. Plasmavorrichtung nach einem der Ansprüche 15 bis 18,
dadurch gekennzeichnet, daß die Halbleiterschaltelemente ($Q_1$, $Q_2$; $Q_3$) einen Bipolartransistor ($Q_3$) enthalten.

21. Plasmavorrichtung nach einem der Ansprüche 11 bis 20,
dadurch gekennzeichnet, daß das nichtlineare Element (M) ein Magnetron ist.

**Revendications**

1. Appareil à plasma comprenant :

un oscillateur hyperfréquence (1 ; 103) pour générer des ondes hyperfréquence,
un circuit hyperfréquence (6 ; 102) pour générer un plasma (18 ; 22 ; 82 ; 94) au moyen d'une décharge d'ondes hyperfréquences à l'intérieur du circuit hyperfréquence (6 ; 102), et
un chemin de transmission (2, 3 ; 104) pour transmettre les ondes hyperfréquence provenant de l'oscillateur hyperfréquence (1 ; 103) au circuit hyperfréquence (6 ; 102),
dans lequel un milieu générateur de plasma pour générer le plasma (18 ; 22 ; 82; 94) est injecté dans un espace (13 ; 46 ; 55 ; 64 ; 125) formé entre une paroi conductrice (11 ; 42 ; 43 ; 53 ; 62 ; 123) et des éléments diélectriques (12 ; 44 ; 54 ; 63 ; 124) installés à l'opposé de la paroi conductrice (11 ; 42 ; 43 ; 53 ; 62 ; 123), et le circuit hyperfréquence (6 ; 102) est agencé pour coupler l'énergie principale des ondes hyperfréquence sur les éléments diélectriques (12 ; 44 ; 54 ; 63 ; 124) de telle sorte qu'un mode hyperfréquence prédéterminé se propage à travers la limite existant entre les éléments diélectriques (12 ; 44 ; 54; 63 ; 124) et le plasma (18 ; 22 ; 82 ; 94),

caractérisé en ce que l'oscillateur hyperfréquence (1 ; 103) est un oscillateur destiné à générer des ondes hyperfréquence pulsées par une fréquence d'impulsion prédéterminée, et
les éléments diélectriques (12 ; 44 ; 54 ; 63 ; 124) et la paroi conductrice (11 ; 42 ; 43 ; 53 ; 62 ; 123) sont configurés de telle sorte que la composante de champ électrique (17 ; 47) dudit mode hyperfréquence est orthogonale par rapport à cette partie de la limite à travers laquelle les ondes hyperfréquence envahissent le plasma (18 ; 22 ; 82 ; 94).

2. Appareil à plasma selon la revendication 1, caractérisé en ce que le milieu générateur de plasma est un gaz de laser $CO_2$.

3. Appareil à plasma selon la revendication 1 ou 2,
caractérisé en ce qu'une rainure (10 ; 78 ; 93 ; 128) est formée sur le conducteur pour constituer une partie du circuit hyperfréquence et en ce que le milieu générateur de plasma est injecté dans un espace (13 ; 125) formé par la couverture d'une partie d'ouverture (81 ; 92) de la rainure (10 ; 78 ; 93 ; 128) en utilisant les éléments diélectriques (12 ; 124) comme fenêtre incidente de l'onde hyperfréquence.

4.  Appareil à plasma selon l'une des revendications précédentes, caractérisé en ce que la surface de paroi du conducteur dans l'espace (13) est revêtue d'une couche céramique (15).

5.  Appareil à plasma selon l'une des revendications précédentes, caractérisé en ce qu'une cuve formant réservoir (31) communique avec l'espace (13) par un ou plusieurs trous d'entrée et de liaison (32) et stocke le milieu générateur de plasma devant remplacer le milieu générateur de plasma dans l'espace (13).

6.  Appareil à plasma selon la revendication 5, caractérisé en ce que les trous d'entrée et de liaison (32) sont équipés d'un organe perméable aux gaz (33) qui réfléchit l'onde hyperfréquence vers l'extrémité du côté de l'espace (13).

7.  Appareil à plasma selon l'une des revendications précédentes, caractérisé en ce qu'un creux (41) comprenant une première paroi de conducteur (42) pour constituer une partie du circuit hyperfréquence en tant que surface inférieure et une seconde paroi conductrice (43) en tant que surface latérale est ménagé, une partie d'ouverture du creux (41) est recouverte par un premier corps diélectrique (44) qui est une fenêtre incidente d'onde hyperfréquence, un second corps diélectrique (45) est agencé sur la second paroi conductrice (43), le milieu produisant le plasma est injecté dans un espace (46) formé par la première paroi conductrice (42), le premier corps diélectrique (44) et le second corps diélectrique (45) et le circuit hyperfréquence (6) forme un mode hyperfréquence ayant une composante de champ électrique (47) orthogonale par rapport à la limite entre le premier corps diélectrique (44) et le plasma généré dans le milieu produisant le plasma.

8.  Appareil à plasma selon l'une des revendications précédentes, caractérisé en ce que l'espace (55) formé entre la paroi conductrice (53) et les éléments diélectriques (54) agit comme guide d'ondes optiques, le gaz du laser est injecté dans l'espace (13 ; 46; 55; 64; 125), l'onde hyperfréquence est entrée en utilisant les éléments diélectriques (54) comme fenêtre incidente d'onde hyperfréquence et le mode hyperfréquence ayant la composante de champ électrique orthogonale par rapport à la limite entre les éléments diélectriques (54) et le plasma généré dans le gaz à laser est formé, moyennant quoi un appareil à laser à gaz du type à guide d'ondes optiques est constitué.

9.  Appareil à plasma selon l'une des revendications précédentes, caractérisé en ce qu'une partie de l'espace (13 ; 64) autre que les éléments diélectriques (12 ; 63) est fabriquée comme un organe perméable aux gaz (33 ; 67) pour réfléchir l'onde hyperfréquence et le gaz de laser dans l'espace (13 ; 64) est mis en circulation par des moyens de circulation à travers l'organe perméable aux gaz (33 ; 67).

10. Appareil à plasma selon l'une des revendications précédentes, caractérisé en ce que le chemin de transmission d'ondes hyperfréquence (2, 3 ; 104) et le circuit hyperfréquence (6 ; 102) sont agencés en parallèle le long de l'axe optique.

11. Appareil à plasma selon l'une des revendications précédentes, caractérisé en ce que l'onde hyperfréquence est pulsée avec une fréquence d'impulsion de 500 Hz ou supérieure.

12. Appareil à plasma selon la revendication 11, caractérisé en ce que le courant continu (CC) est converti en courant alternatif (CA) ayant une fréquence supérieure à la fréquence commerciale grâce à un onduleur CC-CA (26) et élevé en tension par un transformateur (27) et ensuite une onde hyperfréquence pulsée est générée par un oscillateur hyperfréquence (1) actionné par une source d'alimentation (29) pour générer une tension élevée en ondulation par un circuit multiplicateur de tension à une alternance (28).

13. Appareil à plasma selon la revendication 11 ou 12, caractérisé en ce que l'onde hyperfréquence pulsée est générée par un oscillateur hyperfréquence (1) actionné par une source d'impulsions à tension élevée où le courant continu à tension élevée est interrompu par un élément de commutation.

14. Appareil à plasma selon l'une des revendications 11 à 13, caractérisé en ce que l'onde hyperfréquence pulsée présente un temps de repos inférieur à la constante de temporisation thermique du milieu générateur de plasma.

15. Appareil à plasma selon l'une des revendications 11 à 14, caractérisé en ce que l'appareil à source d'alimentation pour fournir une tension pulsée à l'oscillateur hyperfréquence est un appareil à source d'alimentation pour actionner un élément ou dispositif non linéaire (M) lorsque le courant ne circule pas à une tension inférieure à la tension prescrite $E_2$ et le courant circule à la tension prescrite $E_2$ ou supérieure et un élément de commutation à semi-conducteur ($Q_1$, $Q_2$ ; $Q_3$) pour commander la source d'alimentation circulant depuis la source de tension jusqu'à l'élément ou dispositif non linéaire (M) est connecté en série à l'élément ou dispositif non linéaire (M).

**16.** Appareil à plasma selon la revendication 15, caractérisé en ce que l'élément ou dispositif non linéaire (M) est équipé de résistances de division ($R_3$, $R_4$, $R_5$) connectées en parallèle.

**17.** Appareil à plasma selon la revendication 15 ou 16, caractérisé en ce que l'élément de commutation à semi-conducteur ($Q_1$, $Q_2$ ; $Q_3$) présente une tension de résistance qui est inférieure à la tension $E_0$ de la source de tension et supérieure à $E_0$-$E_2$.

**18.** Appareil à plasma selon l'une des revendications 15 à 17, caractérisé en ce qu'une pluralité d'éléments de commutation à semi-conducteurs ($Q_1$, $Q_2$ ; $Q_3$) est connectée en série.

**19.** Appareil à plasma selon l'une des revendications 15 à 18, caractérisé en ce que l'élément de commutation à semi-conducteur ($Q_1$, $Q_2$ ; $Q_3$) est un transistor à effet de champ ($Q_1$, $Q_2$).

**20.** Appareil à plasma selon l'une des revendications 15 à 18, caractérisé en ce que l'élément de commutation à semi-conducteur ($Q_1$, $Q_2$; $Q_3$) est un transistor bipolaire ($Q_3$).

**21.** Appareil à plasma selon l'une des revendications 11 à 20, caractérisé en ce que l'élément non linéaire (M) est un magnétron.

EP 0 674 471 B1

# FIG. 1

# FIG. 2

22

# FIG. 3

# FIG. 4

# FIG. 5

24

# FIG. 6

# FIG. 7

# FIG. 8

# FIG. 9

# FIG. 10

(a)

(b)

(c)

(d)

(g)

(h)

# FIG. 11

(a)

(b)

(c)

# FIG. 12

(a)

12

13

11

# FIG. 12

(b)

12

13

11

13

12

# FIG. 13

(a)  21

12

13

22  11

# FIG. 13

22  (b)  11  21

13

12

# FIG. 14

# FIG. 15

FIG. 16

EP 0 674 471 B1

# FIG. 17

# FIG. 18

FIG. 19

FIG.20

# FIG. 21

(a)

(b)

(c)

FIG. 22

FIG. 23

EP 0 674 471 B1

# FI G. 24

27

# FIG.25

FIG.26

FIG. 27

FIG. 29

FIG. 28

FIG. 30

FIG.31

FIG.32

# FIG. 33

# FIG. 35

FIG. 34

# FIG. 36

# FIG.37

EP 0 674 471 B1

# FIG. 38

FIG. 39